# EUROPEAN PATENT APPLICATION

(11) **EP 4 733 882 A1**
(43) Date of publication of application: **29.04.2026**
(21) Application number: 24826306.3
(22) Date of filing: 21.06.2024
(51) Int. Cl.: G06F 1/16, C09J 7/00, H01M 10/04

(54) **ELECTRONIC DEVICE COMPRISING BATTERY**

(30) Priority: 22.06.2023 KR 20230080613; 14.08.2023 KR 20230106542
(71) Applicant: Samsung Electronics Co., Ltd., Suwon-si, Gyeonggi-do 16677 (KR)
(72) Inventor: YU, Jaewon, Suwon-si, Gyeonggi-do 16677 (KR); KIM, Inhwan, Suwon-si, Gyeonggi-do 16677 (KR); YANG, Soohyeon, Suwon-si, Gyeonggi-do 16677 (KR)
(74) Representative: Appleyard Lees IP LLP
(86) International application number: PCT/KR2024/008620
(87) International publication number: WO 2024/262991

(57) **Abstract**

An electronic device according to one embodiment disclosed herein may comprise: a housing; a support member including a first surface, a second surface facing the opposite direction as the first surface, and a third surface perpendicular to both the first surface and the second surface, and accommodated in the housing, and a battery disposed on the first surface of the support member and including a battery cell and a tape surrounding at least a portion of the battery cell. The tape may surround at least a portion of the support member in a state in which the battery is disposed on the first surface of the support member, and at least a portion of the tape may be disposed on a fourth surface parallel to the first surface of the support member. Various other embodiments may also be possible.

## Description

### [Technical Field]

Embodiment(s) of the disclosure relate to an electronic device including a battery and a member for fixing the battery.

### [Background Art]

Due to the development of information and communications technology and semiconductor technology, the supply and use of various electronic devices are rapidly increasing. In particular, recent electronic devices have been developed to be portable for communication. These electronic devices are miniaturized so that users may conveniently carry them. Along with the trend toward miniaturization of electronic devices, research to increase a battery capacity or a battery life is actively underway so that users may use the electronic devices for a long time. Further, research to improve battery safety is also actively pursued.

The above information is presented as related art only to assist with an understanding of the disclosure. No determination has been made, and no assertion is made, as to whether any of the above might be applicable as prior art with regard to the disclosure.

### [Detailed Description of the Invention]

### [Technical Solution]

An electronic device according to an embodiment of the disclosure may include a housing 201, a support member which includes a first surface, a second surface facing in a direction opposite to the first surface, and a third surface 220c different from the first surface and the second surface, and is accommodated in the housing, and a battery disposed on the first surface of the support member, and including a battery cell and at least one tape surrounding at least a portion of the battery cell. In a state in which the battery is disposed on the first surface of the support member, the at least one tape may surround at least a portion of the support member, and may be at least partially disposed on a fourth surface stepped by a predetermined height from the first surface of the support member.

An electronic device according to an embodiment of the disclosure may include a housing, a support member which includes a first portion including a first surface and a second surface facing in a direction opposite to the first surface, and a second portion including a third surface different from the first surface and the second surface, and a battery disposed on the first surface of the first portion of the support member, and including a battery cell 251 and at least one tape surrounding at least a portion of the battery cell. The at least one tape may include a double-sided tape and a wing-shaped tape which at least partially passes through a hole formed on the third surface of the support member to surround at least a portion of the support member, and is at least partially disposed on the fourth surface 220d stepped by a predetermined height from the first surface of the support member.

### [Brief Description of Drawings]

The above or other aspects, configurations, and/or advantages according to an embodiment of the disclosure may become more apparent from the following detailed description with reference to the accompanying drawings.
FIG. 1 is a block diagram illustrating an electronic device in a network environment according to an embodiment of the disclosure.
FIG. 2 is a front perspective view illustrating an electronic device according to an embodiment of the disclosure.
FIG. 3 is a rear perspective view illustrating the electronic device shown in FIG. 2 according to an embodiment of the disclosure.
FIG. 4 is an exploded front perspective view illustrating the electronic device shown in FIG. 2 according to an embodiment of the disclosure.
FIG. 5 is an exploded rear perspective view illustrating the electronic device shown in FIG. 2 according to an embodiment of the disclosure.
FIG. 6 is a conceptual view illustrating a state where an impact is applied to an electronic device when the electronic device is dropped, according to an embodiment of the disclosure.
FIG. 7 is a conceptual view illustrating a state where an impact is applied to an electronic device when the electronic device is dropped, according to an embodiment of the disclosure.
FIG. 8 is a perspective view illustrating a battery including a double-sided tape and a wing-shaped tape according to an embodiment of the disclosure.
FIG. 9 is a perspective view illustrating a battery further including a release liner according to an embodiment of the disclosure.
FIG. 10 is a diagram illustrating a battery to which a wing-shaped tape is attached according to an embodiment of the disclosure.
FIG. 11 is a diagram illustrating a wing-shaped tape according to an embodiment of the disclosure.
FIG. 12 is a diagram illustrating a state where a release liner is attached to a wing-shaped tape according to an embodiment of the disclosure.
FIG. 13 is a diagram illustrating a state where a wing-shaped tape is attached to a battery according to an embodiment of the disclosure.
FIG. 14 is a diagram illustrating a state where a wing-shaped tape is attached to a battery according to an embodiment of the disclosure.
FIG. 15 is a diagram illustrating the position of a center of gravity of an electronic device based on arrangement of various components according to an embodiment of the disclosure.
FIG. 16 is a cross-sectional view illustrating an electronic device according to an embodiment of the disclosure.
FIGS. 17A, 17B, 17C, and 17D are diagrams illustrating a state where a battery is assembled to an electronic device according to an embodiment of the disclosure.
FIGS. 18A, 18B, and 18C are perspective views illustrating a fixing member for fixing at least one tape to a support member according to an embodiment of the disclosure.
FIGS. 19A and 19B are cross-sectional views illustrating a fixing member for fixing at least one tape to a support member according to an embodiment of the disclosure.
FIGS. 20A, 20B, and 20C are perspective views illustrating a cover for fixing at least one tape to a support member according to an embodiment of the disclosure.
FIG. 21 is a diagram illustrating a separated wing-shaped tape according to an embodiment of the disclosure.
FIGS. 22A and 22B are diagrams illustrating a state where a battery is assembled to an electronic device according to an embodiment of the disclosure.
FIGS. 23A, 23B, 23C, 23D, and 23E are diagrams illustrating a state where a wing-shaped tape is assembled to an electronic device according to an embodiment of the disclosure.

Throughout the accompanying drawings, similar reference numerals may be assigned to similar components, configurations, and/or structures.

### [Mode for Carrying out the Invention]

Conventionally, when an electronic device is dropped, a window portion is damaged due to the movement of a battery disposed inside the electronic device. For example, in the case where a support member (e.g., a bracket) is manufactured using a thin press, damage caused by the dropping of the electronic device may be concentrated mainly in an area corresponding to the perimeter of the battery.

An embodiment of the present disclosure is to address at least the above-mentioned problems and/or disadvantages and to provide at least the advantages described below, and may provide an electronic device that prevents or reduces damage of the electronic device or internal components of the electronic device caused by a battery, when the electronic device is dropped.

The technical objects to be achieved in the disclosure are not limited to those mentioned above, and other technical objects not mentioned will be clearly understood by those skilled in the art from the following description.

The following description with reference to the accompanying drawings may provide an understanding of various exemplary implementations of the disclosure, including the claims and corresponding content. Although the exemplary embodiments disclosed in the following description include various specific details for the purpose of aiding understanding, they are considered to be one of various exemplary embodiments. Accordingly, those skilled in the art will understand that various changes and modifications may be made to the various implementations described herein without departing from the scope and spirit of the disclosure. Further, a description of well-known functions and configurations will be avoided for clarity and conciseness.

The terms and words used in the following description and claims are not limited to referential meanings but may be used to clearly and consistently describe an embodiment of the disclosure. Accordingly, it will be apparent to those skilled in the art that the following description of various implementations of the disclosure is provided for purposes of illustration and not for the purpose of limiting the disclosure as defined by the scope of the claims and their equivalents.

Unless the context clearly dictates otherwise, it is to be understood that the singular forms "a," "an," and "the" include plural referents. Therefore, for example, a reference to "a component surface" may be understood to include one or more of the surfaces of the component.

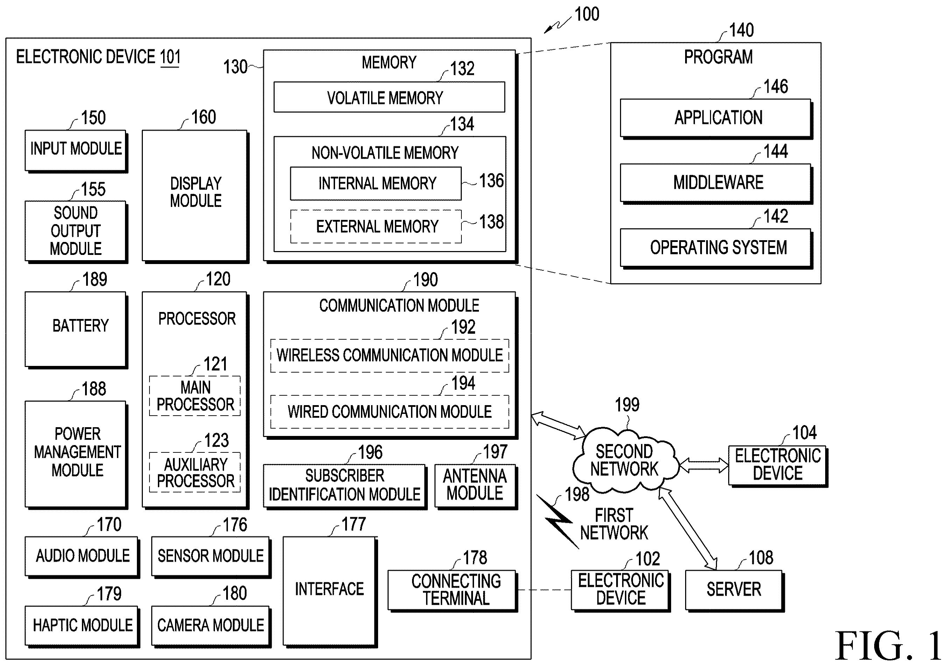

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the strength of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form an mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

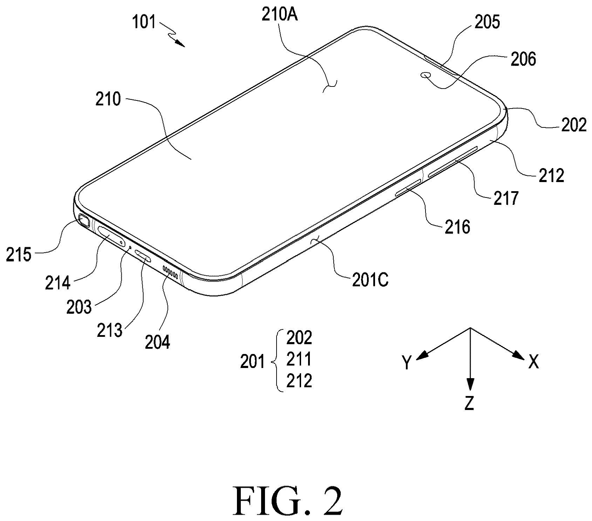

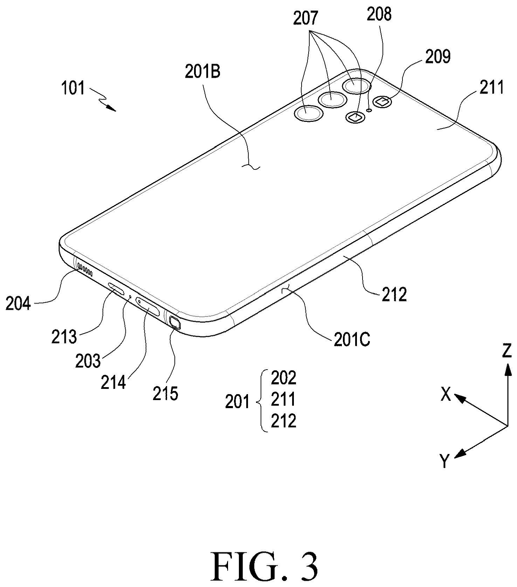

FIG. 2 is a front perspective view illustrating the electronic device 101 according to various embodiments of the disclosure. FIG. 3 is a rear perspective view illustrating the electronic device 101 according to various embodiments of the disclosure.

In the following detailed description, a length direction of the electronic device 101 may be defined as a 'Y-axis direction,' a width direction as an 'X-axis direction,' and/or a height (or thickness) direction as a 'Z-axis direction.' The mention of the length direction, width direction, and/or height (or thickness) direction in the following detailed description may refer to the length direction, width direction, and/or height (or thickness) direction of the electronic device. In some embodiments, for a direction in which a component faces, 'negative/positive (-/+)' may be mentioned along with the Cartesian coordinate system illustrated in the drawings. For example, referring to FIG. 2, the front surface of the electronic device 101 or a housing 201 may be defined as a 'surface facing in the -Z-axis direction,' and the rear surface as a 'surface facing in the +Z-axis direction.' According to an embodiment, an arrangement relationship in the height direction of a component or another component, that is, a reference for up/down, may follow the +Z-axis direction/-Z-axis direction. That is, a component being disposed on another component may mean that the component is disposed in the -Z-axis direction relative to the other component, and a component being disposed under another component may mean that the component is disposed in the +Z-axis direction relative to the other component. Meanwhile, it should be noted that even if a component is disposed on or under another component, it does not mean that the entire component is located entirely on or under the other component. For example, it should be noted that a portion of the component may be disposed on a portion of the other component, while another portion of the component may be disposed under another portion of the other component. According to an embodiment, when it is said that 'a component is viewed from above,' this may mean viewing the component in the +Z-axis direction from the -Z-axis direction at a position at a specific height away from the component. According to an embodiment, a component 'facing in a specific direction' may be understood to include not only the component facing in the same direction as the 'specific direction' but also the component facing in a direction parallel to the 'specific direction.' In the following description, when it is said that a component overlaps (or is stacked with) another component, it should be noted that the description of the arrangement relationship in the height direction mentioned above may apply. In describing a direction, when 'negative/positive (-/+)' is not stated, it may be interpreted to include both the + and - directions unless separately defined. For example, the 'Z-axis direction' may be interpreted to include both the +Z and -Z directions. Similarly, the 'X-axis direction' may be interpreted to include both the +X and -X directions, and the 'Y-axis direction' may be interpreted to include both the +Y and -Y directions. In describing a direction, facing one of the three axes of the Cartesian coordinate system may include facing in a direction parallel to the axis. In the following description, a 'first direction' may mean the Z-axis direction or a direction parallel to the Z axis, a 'second direction' may mean the X-axis direction or a direction parallel to the X axis, and a 'third direction' may mean the Y-axis direction or a direction parallel to the Y axis. It should be noted that the above description is based on the Cartesian coordinate system described in the drawings for brevity of description, and the description of directions or components does not limit various embodiments of the disclosure.

Referring to FIGS. 2 and 3, the electronic device 101 according to an embodiment may include the housing 201 which includes a front surface 201A, a rear surface 201B, and a side surface 201C surrounding a space between the front surface 201A and the rear surface 201B. In another embodiment (not shown), the housing 201 may refer to a structure that forms a portion of the front surface 201A of FIG. 2, the rear surface 201B of FIG. 3, and the side surface 201C. According to an embodiment, at least a portion of the front surface 201A may be formed by a front plate 202 (e.g., a glass plate or polymer plate including various coating layers) at least a portion of which is substantially transparent. The rear surface 201B may be formed by a rear plate 211. The rear plate 211 may be formed of, for example, glass, ceramic, a polymer, a metal (e.g., aluminum, stainless steel (STS), or magnesium), or a combination of at least two of these materials. The side surface 201C may be coupled to the front plate 202 and the rear plate 211 and formed by a side bezel structure (or "side member") 212 including a metal and/or a polymer. In some embodiments, the front plate 202 and the side bezel structure 212 may be integrally formed into one body and include the same material. Alternatively, the rear plate 211 and the side bezel structure 212 may be integrally formed into one body and include the same material (e.g., glass, a metallic material such as aluminum, or ceramic). In another embodiment, the front surface 201A and/or the front plate 202 may be interpreted as a portion of a display 210. According to an embodiment, the housing 201 may include the front plate 202 and the rear plate 211.

According to an embodiment, the electronic device 101 may include at least one of the display 210, audio modules 203, 204, and 205 (e.g., the audio module 170 of FIG. 1), a sensor module (e.g., the sensor module 176 of FIG. 1), camera modules 206 and 207 (e.g., the camera module 180 of FIG. 1), key input devices 216 and 217 (e.g., the input module 150 of FIG. 1), or connector holes 213 and 214 (e.g., the connecting terminal 178 of FIG. 1). In some embodiment, the electronic device 101 may not be provided with at least one (e.g., the connector hole 214) of the components or may additionally include other components.

According to an embodiment, the display 210 may be visually exposed, for example, through a substantial portion of the front plate 202. In some embodiments, at least a portion of the display 210 may be exposed through the front plate 202 that forms the front surface 201A. According to an embodiment, the display 210 may be a flexible display or a foldable display.

According to an embodiment, a surface (or the front plate 202) of the housing 201 may include a screen display area formed by the visual exposure of the display 210. For example, the screen display area may include the front surface 201A.

In another embodiment (not shown), a recess or an opening may be formed in a portion of the screen display area (e.g., the front surface 201A) of the display 210, and at least one of the audio module 205, a sensor module (not shown), a light emitting element (not shown), or the camera module 206, which is aligned with the recess or the opening, may be included. In another embodiment (not shown), at least one of the audio module 205, the sensor module (not shown), the camera module 206, a fingerprint sensor (not shown), or the light emitting element (not shown) may be included on the rear surface of the screen display area of the display 210.

In another embodiment (not shown), the display 210 may be incorporated with or disposed adjacent to a touch sensing circuit, a pressure sensor capable of measuring the intensity (pressure) of a touch, and/or a digitizer that detects a magnetic field-based stylus pen 215.

In some embodiments, at least some of the key input devices 216 and 217 may be disposed on the side bezel structure 212.

According to an embodiment, the audio modules 203, 204, and 205 may include, for example, a microphone hole 203 and speaker holes 204 and 205. A microphone for obtaining an external sound may be disposed in the microphone hole 203, and in some embodiments, a plurality of microphones may be disposed to detect the direction of a sound. The speaker holes 204 and 205 may include an external speaker hole 204 and a receiver hole 205 for calls. In some embodiments, the speaker holes 204 and 205 and the microphone hole 203 may be implemented as a single hole, or a speaker (e.g., a piezo speaker) may be included without the speaker holes 204 and 205. The audio modules 203, 204, and 205 are not limited to the above-described structure, and various design modifications, such as mounting only some audio modules or adding a new one, may be made depending on the structure of the electronic device 101.

According to an embodiment, the sensor module (not shown) may generate an electrical signal or data value corresponding to an internal operation state of the electronic device 101 or an external environmental state. The sensor module (not shown) may include, for example, a first sensor module (not shown) (e.g., a proximity sensor) and/or a second sensor module (not shown) (e.g., a fingerprint sensor), disposed on the front surface 201A of the housing 201, and/or a third sensor module (not shown) (e.g., a HRM sensor) and/or a fourth sensor module (not shown) (e.g., a fingerprint sensor), disposed on the rear surface 201B of the housing 201. In some embodiments (not shown), the fingerprint sensor may be disposed on the rear surface 201B as well as on the front surface 201A (e.g., the display 210) of the housing 201. The electronic device 101 may further include a sensor module which is not shown, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor (not shown). The sensor module (not shown) is not limited to the above-described structure, and various design modifications, such as mounting only some sensor modules or adding a new one, may be made depending on the structure of the electronic device 101.

According to an embodiment, the camera modules 206 and 207 may include a front camera module 206 disposed on the front surface 201A of the electronic device 101, and a rear camera module 207, a flash 208, and/or an IR sensor 209 disposed on the rear surface 201B of the electronic device 101. The camera modules 206 and 207 may include one or more lenses, an image sensor, and/or an image signal processor. The flash 208 may include, for example, a light emitting diode (LED) or a xenon lamp. The camera modules 206 and 207 are not limited to the above-described structure, and various design modifications, such as mounting only some camera modules or adding a new one, may be made depending on the structure of the electronic device 101.

According to an embodiment, the electronic device 101 may include a plurality of camera modules (e.g., a dual or triple camera) each with a different attribute (e.g., angle of view) or function. For example, the rear camera module 207 may include a plurality of camera modules with lenses having different angles of view. For example, the plurality of camera modules may include at least one of a wide-angle camera, an ultra-wide-angle camera, a telephoto camera, or an IR camera (e.g., a time of flight (TOF) camera or a structured light camera). Further, the plurality of camera modules may include, for example, an optical zoom camera with an adjustable magnification. According to an embodiment, for the plurality of camera modules, the electronic device 101 may be configured such that a designated camera module operates, or another camera module operates, based on a user's selection or under a pre-specified environment. According to an embodiment, the IR camera may operate as at least part of a sensor module. For example, a TOF camera may operate as at least part of a sensor module (not shown) for sensing the distance to a subject.

According to an embodiment, the camera modules 206 and 207 of the disclosure may include a vertical camera module and/or a folded camera module. The vertical camera module may be a camera module in which the path of light entering a lens assembly and reaching an image sensor is formed in a straight line without bending. In the vertical camera module, a relative motion between a lens barrel and a camera housing that surrounds the lens barrel (or a relative motion between the image sensor and the camera housing) may be made during an auto focus (AF) operation or an optical image stabilization (OIS) operation. Further, the vertical camera module may also include a camera module in which a lens barrel and a camera housing are fixed in position without moving relatively, such as a fixed focus type camera module. The folded camera module may be a camera module in which the path of light reaching an image sensor from a lens assembly bends at least once. The folded camera module may typically include a member (e.g., a prism or a mirror) that reflects or refracts light at least once. Whether the path in which light reaches the image sensor is bent is determined not based on the light being bent by individual lenses included in the lens assembly, but based on the light being bent by the member (e.g., a prism or a mirror). According to an embodiment, some (e.g., the front camera) of the camera modules 206 and 207 may include a vertical camera module, while the other (e.g., the rear camera) may include a folded camera module.

Additionally, according to an embodiment, some (e.g., the front camera module 206) of the camera modules 206 and 207 may be implemented as an under display camera (UDC).

According to an embodiment, the key input devices 216 and 217 may be arranged on the side surface 201C of the housing 201. In another embodiment, the electronic device 101 may not include some or any of the key input devices 216 and 217, and the key input devices 216 and 217 which are not included may be implemented in other forms such as soft keys on the display 210. In some embodiments, the key input devices 216 and 217 may include a sensor module (not shown) disposed on the rear surface 210B of the housing 201.

According to an embodiment, the light emitting element (not shown) may be disposed, for example, on the front surface 201A of the housing 201. The light emitting element (not shown) may provide, for example, state information about the electronic device 101 in the form of light. In another embodiment, the light emitting element (not shown) may provide, for example, a light source interworking with an operation of the front camera module 206. The light emitting element (not shown) may include, for example, an LED, an IR LED, and/or a xenon lamp.

According to an embodiment, the connector holes 213 and 214 may include a first connector hole 213 capable of accommodating a connector (e.g., a USB connector) for transmitting and receiving power and/or data to and from an external electronic device and/or a second connector hole 214 capable of accommodating a storage device (e.g., a subscriber identification module (SIM) card and a secure digital (SD) memory card). According to an embodiment, the first connector hole 213 and/or the second connector hole 214 may be omitted. The connector holes 213 and 214 are not limited to the above-described structure, and various design modifications, such as mounting only some connector holes or adding a new one, may be made depending on the structure of the electronic device 101.

The pen input device 215 (e.g., a stylus pen) may be guided into and detached from the inside of the housing 201 through a hole formed on the side surface of the housing 201, and include a button to facilitate insertion and detachment. The pen input device 215 may have a separate built-in resonance circuit and interwork with an electromagnetic induction panel (e.g., a digitizer) included in the electronic device 101. The pen input device 215 may include electromagnetic resonance (EMR), active electrical stylus (AES), and electric coupled resonance (ECR) methods.

The electronic device 101 illustrated in FIGS. 2 and 3 has, but is not limited to, a bar-type or plate-type appearance. For example, the illustrated electronic device may be a portion of a rollable electronic device or a foldable electronic device. A "rollable electronic device" may refer to an electronic device in which a display is capable of bending deformation, allowing at least a portion thereof to be wound or rolled and stored inside the housing 201. Depending on user needs, the rollable electronic device may expand the screen display area by unrolling the display or exposing a larger area of the display to the outside. A "foldable electronic device" may refer to an electronic device in which two different areas of a display are foldable to face each other or face in opposite directions. Generally, in a portable state, the two different areas of the display in the foldable electronic device face each other or in opposing directions. In an actual use state, the user may unfold the display so that the two different areas are substantially flat. In some embodiments, the electronic device 101 according to various embodiments of the disclosure may be interpreted to include not only portable electronic devices like a smartphone but also other various electronic devices like a laptop computer or a home appliance.

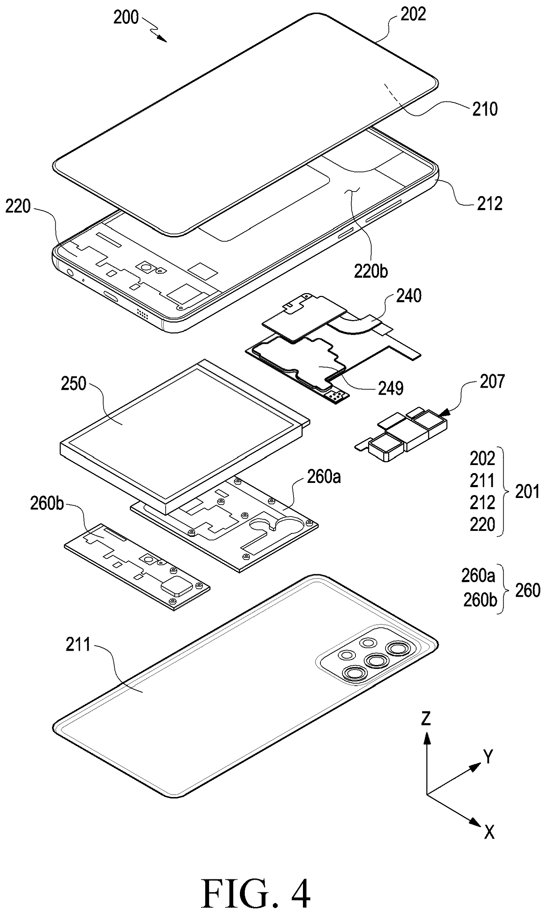

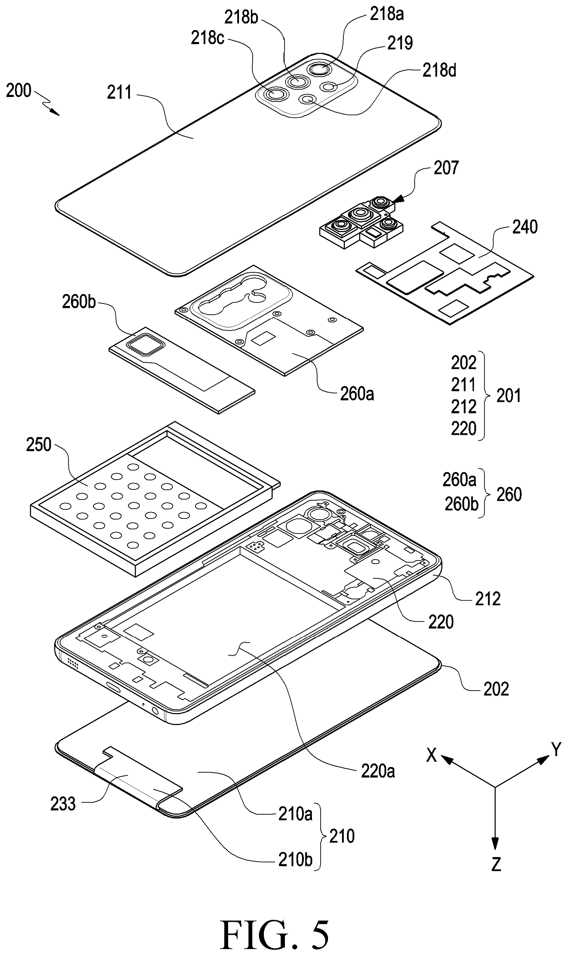

FIG. 4 is an exploded front perspective view illustrating the electronic device shown in FIG. 2 according to an embodiment of the disclosure. FIG. 5 is an exploded rear perspective view illustrating the electronic device shown in FIG. 2 according to an embodiment of the disclosure.

Referring to FIGS. 4 and 5, the electronic device 200 (e.g., the electronic device 101 in FIG. 1, FIG. 2, or FIG. 3) may include the side bezel structure 212, a first support member 220 (e.g., a bracket), the front plate 202, the display 210, a PCB (or a board assembly) 240, a battery 250, a second support member 260 (e.g., a rear case), an antenna, the camera module 207, and the rear plate 211. In an embodiment, the electronic device 200 may not be provided with at least one (e.g., the first support member 220 or the second support member 260) of the components or may additionally include other components. At least one of the components of the electronic device 200 may be identical or similar to at least one of the components of the electronic device 101 in FIG. 2 or FIG. 3, and any redundant description will be avoided below.

The first support member 220 may be disposed inside the electronic device 200 and connected to the side bezel structure 212, or may be formed integrally with the side bezel structure 212. The first support member 220 may be formed of, for example, a metallic material and/or a non-metallic (e.g., polymer) material. When formed at least partially of a metallic material, a portion of the side bezel structure 212 or the first support member 220 may function as an antenna. The first support member 220 may have one surface coupled to the display 210 and the other surface coupled to the PCB 240. A processor (e.g., the processor 120 of FIG. 1), memory (e.g., the memory 130 of FIG. 1), and/or an interface (e.g., the interface 177 of FIG. 1) may be mounted on the PCB 240. The processor may include, for example, one or more of a central processing unit, an application processor, a graphics processing unit, an image signal processor, a sensor hub processor, or a communication processor. In an embodiment, the processor and/or the memory may refer to one of the circuit devices mounted on an integrated circuit chip. According to an embodiment, the first support member 220 may include a first surface 220a on which the battery 250 to be described later is seated, and a second surface 220b facing in a direction opposite to the first surface 220a.

According to an embodiment, the first support member 220 and the side bezel structure 212 may be combined to be referred to as a front case or the housing 201. According to an embodiment, the housing 201 may be generally understood as a structure for accommodating, protecting, or disposing the PCB 240 or the battery 250. In an embodiment, the housing 201 may be understood as including a structure that may be visually or tactilely recognized by a user on the exterior of the electronic device 200, for example, the side bezel structure 212, the front plate 202, and/or the rear plate 211. In an embodiment, the 'front or rear surface of the housing 201' may refer to the first surface 110A of FIG. 2 or the second surface 110B of FIG. 3. In an embodiment, the first support member 220 may be located between the front plate 202 (e.g., the first surface 110A of FIG. 2) and the rear plate 211 (e.g., the second surface 110B of FIG. 3) and function as a structure on which electrical/electronic components such as the PCB 240 or the camera assembly 207 are disposed.

The display 210 may include a display panel 210a and a flexible printed circuit board (FPCB) 210b extending from the display panel 210a. The FPCB 210b may be understood as being at least partially disposed on the rear surface of the display panel 210a and electrically connected to the display panel 210a. In an embodiment, reference numeral '210a' may be understood as denoting a protective sheet disposed on the rear surface of the display panel. For example, unless separately distinguished in the following detailed description, the protective sheet may be understood as a portion of the display panel 210a. In an embodiment, the protective sheet may function as a cushioning structure (e.g., a low-density elastic material like a sponge) that absorbs an external force or as an electromagnetic shielding structure (e.g., a copper (CU) sheet). According to an embodiment, the display 210 may be disposed on an inner surface of the front plate 202, and output a screen through at least a portion of the first surface 110A of FIG. 2 or the front plate 202 by including a light emitting layer. As described before, the display 210 may output a screen substantially across the entire area of the first surface 110A of FIG. 2 or the front plate 202.

The memory may include, for example, volatile memory or non-volatile memory.

The interface may include, for example, a high definition multimedia interface (HDMI), a universal serial bus (USB) interface, an SD card interface, and/or an audio interface. The interface may, for example, electrically or physically connect the electronic device 200 to an external electronic device, and include a USB connector, an SD card/MMC connector, or an audio connector.

The second support member 260 may include, for example, an upper support member 360a and a lower support member 260b. In an embodiment, the upper support member 360a may be disposed to surround the PCB 240, together with a portion of the first support member 220. For example, the PCB 240 may be disposed substantially between the first support member 220 and the second support member 260 (e.g., the upper support member 260a). A circuit device (e.g., a processor, a communication module, or memory) implemented in the form of an integrated circuit chip or various electrical/electronic components may be disposed on the PCB 240, and according to an embodiment, the PCB 240 may be provided with an electromagnetic shielding environment from the upper support member 260a. In an embodiment, at least one shield can 249 may be disposed on the PCB 240. For example, the shield can 249 may provide an electromagnetic shielding environment to a partial area or space on the PCB 240. In an embodiment, the shield can 249 may be disposed to surround at least a portion of an integrated circuit chip on which the process, the memory, and/or the communication module is mounted.

According to an embodiment, the lower support member 260b may be used as a structure on which electrical/electronic components such as a speaker module and an interface (e.g., a USB connector, an SD card/MMC connector, or an audio connector) may be disposed. In an embodiment, electrical/electronic components such as a speaker module and an interface (e.g., a USB connector, an SD card/MMC connector, or an audio connector) may be disposed on an additional PCB (not shown). For example, the lower support member 260b may be disposed to surround the additional PCB, together with another portion of the first support member 220. The speaker module or interface disposed on the additional PCB (not shown) or the lower support member 260b may be disposed to correspond to an audio module (e.g., the microphone hole 203 or a speaker hole (e.g., the external speaker hole 204 or the receiver hole 205 for calls)) or a connector hole (e.g., the first connector hole 213 or the second connector hole 214) in FIG. 2.

The battery 250, which is a device for supplying power to at least one component of the electronic device 200, may include, for example, a non-rechargeable primary battery, a rechargeable secondary battery, or a fuel cell. At least a portion of the battery 250 may be disposed substantially on the same plane as, for example, the PCB 240. The battery 250 may be integrally disposed within the electronic device 200, and may also be detachably disposed in the electronic device 200.

Although not shown, the antenna may include a conductive pattern implemented on a surface of the first support member 220 and/or a surface of the second support member 260, for example, by laser direct structuring (LDS). In an embodiment, the antenna may include a printed circuit pattern formed on the surface of a thin film, and the thin film-type antenna may be disposed between the rear plate 211 and the battery 250. The antenna may include, for example, a near field communication (NFC) antenna, a wireless charging antenna, and/or a magnetic secure transmission (MST) antenna. The antenna may, for example, perform short-range communication with an external device or wirelessly transmit and receive power required for charging. In an embodiment, another antenna structure may be formed by a portion or combination of the side bezel structure 212 and/or the first support member 220.

The camera assembly 207 may include at least one camera module. Inside the electronic device 200, the camera assembly 207 may receive at least a portion of light incident through an optical hole or camera windows 218a, 218b, 218c, 218d, and 219. In an embodiment, the camera assembly 207 may be disposed on the first support member 220 at a location adjacent to the PCB 240. In an embodiment, the camera module(s) of the camera assembly 207 may be generally aligned with one of the camera windows 218a, 218b, 218c, 218d, and 219 and at least partially surrounded by the second support member 260 (e.g., the upper support member 260a).

For embodiments described below, the configurations of the electronic devices 101 and 200 may be referred to. Even if not directly mentioned, the configurations of the embodiments described above may be applied similarly to the embodiments described below. It should be noted that the Cartesian coordinate system referenced in the above and/or following embodiments is illustrated for the sake of conciseness of description, and the embodiment(s) of the disclosure are not limited thereto. For example, the Cartesian coordinate system mentioned in the disclosure may be defined differently depending on the actual form (e.g., bar type, foldable type, rollable type, and/or slide type) of the electronic device to be manufactured, the usage habits of the user, and/or the orientation direction of the electronic device. In the illustrated embodiments, the X-axis direction may refer to the width direction of the electronic device, the Y-axis direction may refer to the length direction of the electronic device, and/or the Z-axis direction may refer to the thickness direction of the electronic device. In the embodiments to be described later, when an integrated circuit chip generates heat, the heat may move to a heat dissipation member through a heat conducting material, and a direction in which the heat moves may be understood as being substantially parallel to the Z-axis direction.

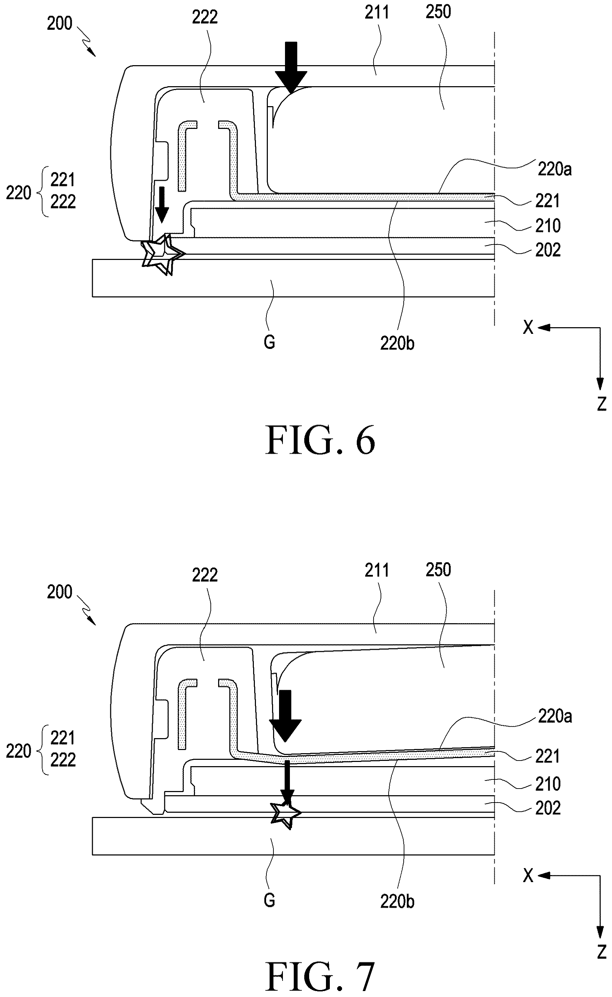

FIG. 6 is a conceptual diagram illustrating the application of impact to an electronic device, when it is dropped, according to an embodiment of the disclosure. FIG. 7 is a conceptual diagram illustrating the application of impact to an electronic device, when it is dropped, according to an embodiment of the disclosure.

Referring to FIGS. 6 and 7, a description will be given of impact applied to the exterior of the electronic device and its internal components, when the electronic device is dropped, and a behavior regarding the resulting damage to the electronic device.

The electronic device 200 may include the battery 250 seated on the first surface 220a of the support member 220. According to an embodiment, the display 210 and the front plate 202 (e.g., a window) may be stacked on the second surface 220b of the support member 220. As illustrated in FIG. 6, when the electronic device 200 is dropped, a physical impact may be applied to the exterior of the electronic device 200, for example, to the front plate 202 or the side bezel structure, and/or the rear plate 211. Referring to FIG. 7, due to this primary impact and/or drop inertia applied to the electronic device 200, a secondary impact may be applied to the internal components of the electronic device. For example, stress may be concentrated on a portion of the support member 220 on which the battery 250 is seated, causing it to bend. This bending may then apply a strong impact to the display 210 and a window member 202.

In describing the embodiments of FIGS. 6 and 7, the support member 220 is exemplified as one that includes a thin plate 221 manufactured by a press method. The support member 220 may include, for example, a very thin plate 221 of 0.3mm or less and an injection molded structure 222 coupled to the plate 221. According to an embodiment, the support member 220 of the disclosure may include two different parts including two different materials (or substances). A first material may include a non-metallic material, and a second material may be a metallic material. For example, the support member 220 may include the plate 221 (hereinafter, referred to as a 'first portion 221') and the injection molded structure 222 (hereinafter referred to as a 'second portion 222'). However, it should be noted that the support member 220 of the disclosure is not necessarily limited to a support member manufactured by this press method. For example, the support member 220 produced by a die casting, full front, full metal, or ruggedize manufacturing method may also be applied as an example of the support member 220.

The disclosure may provide various embodiments for preventing and/or reducing damage to the electronic device caused by the battery in a drop situation such as the embodiments illustrated in FIGS. 6 and 7.

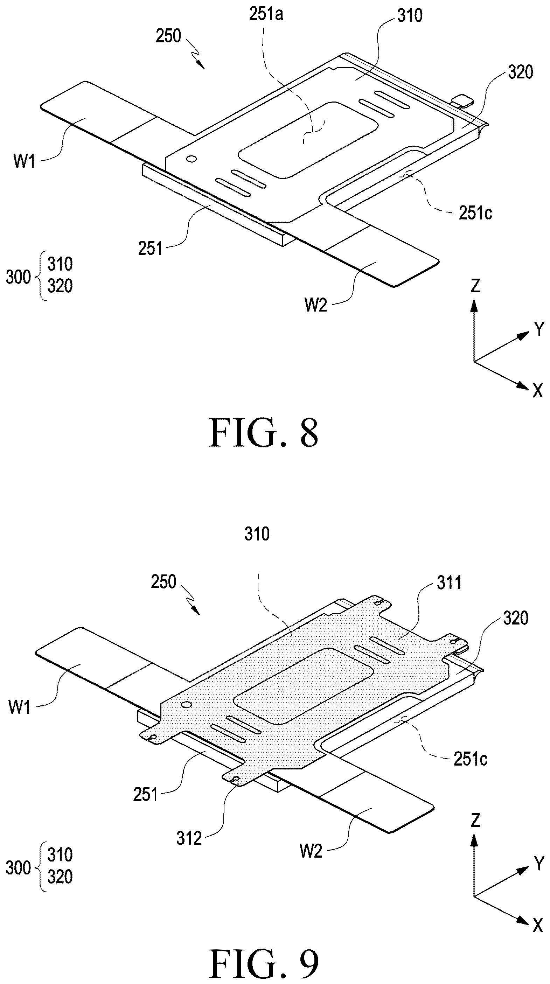

FIG. 8 is a perspective view illustrating a battery including a double-sided tape and a wing-shaped tape according to an embodiment of the disclosure. FIG. 9 is a perspective view illustrating a battery further including a release liner according to an embodiment of the disclosure.

According to an embodiment of the disclosure, the electronic device 200 may include the battery 250 that includes a battery cell 251 and a tape surrounding at least a portion of the battery cell 251.

The battery cell 251 may have a structure that includes a positive electrode assembly, a negative electrode assembly, and an electrolyte, and is accommodated within a battery case. The battery cell 251 may be formed by stacking or winding a stack of the positive electrode assembly which has a positive electrode active material coated on the surface of a thin plate- or film-shaped positive electrode substrate, the negative electrode assembly which has a negative electrode active material coated on the surface of a thin plate- or film-shaped negative electrode substrate, and a separator. The separator may be located between the positive and negative electrode assemblies and function to prevent short circuit while enabling the movement of ions. The battery 250 may be designed in various ways according to the arrangement of internal structures of the battery cell 251 and the resulting shape. For example, representative shapes of the battery 250 may include a pouch type, a cylindrical type, a prismatic type, and a can type. The battery may be released as various products with different specifications depending on embodiments. Therefore, information about a product, such as a storage capacity and handling precautions, may be displayed on one surface of the battery 250.

Referring to FIGS. 8 and 9, a tape 300 may include, for example, a double-sided tape 310 and/or a wing-shaped tape 320. According to an embodiment, the wing-shaped tape 320 may be attached to a first surface of the battery 250 (a first surface 251a of the battery cell), and the double-sided tape 310 may be disposed at a position that at least partially overlaps a position where the wing-shaped tape 320 is attached to the battery 250, such that the double-sided tape 310 at least partially overlaps the wing-shaped tape 320.

According to an embodiment, the double-sided tape 310 may be a component for firmly fixing the battery 250 to a first surface 220a of the support member 220. According to an embodiment, the double-sided tape 310 may be attached to the battery 250 in a state where the wing-shaped tape 320 is attached to one surface of the double-sided tape 310, and a release liner 311 is attached to the other surface of the double-sided tape 310. When the battery 250 is assembled to the electronic device 200, the first surface 220a of the support member 220 may face a portion of the double-sided tape 310 where the release liner 311 is attached. Then, the release liner 311 may be removed by pulling a handle portion 312 of the release liner 311. Once an adhesive portion covered by the release liner 311 is exposed, this adhesive portion may face and be seated on the first surface 220a of the support member 220.

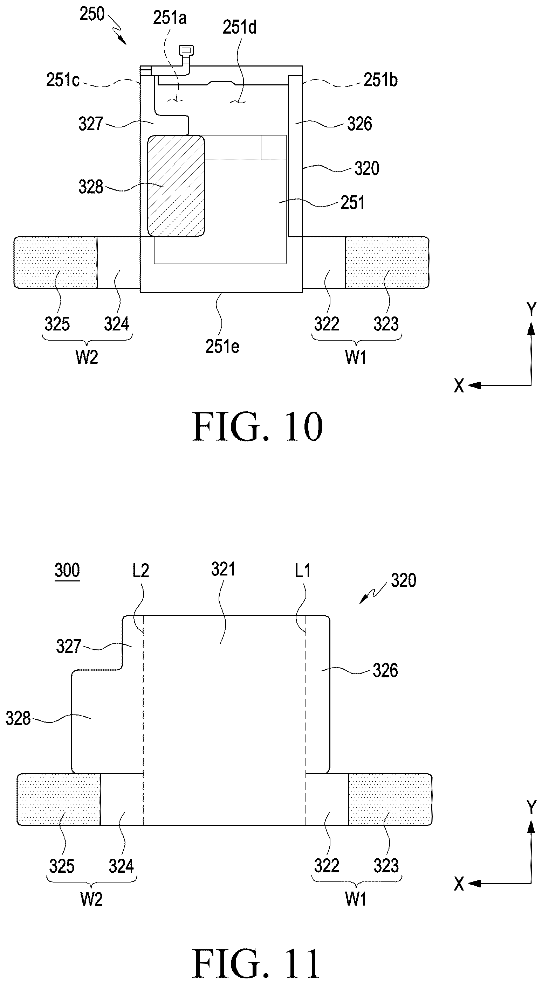

According to an embodiment, the wing-shaped tape 320 may be configured to surround the battery cell 251 in at least three different directions. According to an embodiment, the wing-shaped tape 320 may include a portion (hereinafter, referred to as a base portion 321 to be described later in the embodiment of FIG. 11) corresponding to the first surface 251a of the battery cell 251, and a first wing portion W1 and a second wing portion W2 that respectively surround at least portions of a second surface and a third surface 251c of the battery cell 251. According to another embodiment, at least a portion of the wing-shaped tape 320 may be fully spread out so that all its components are arranged on a single plane (e.g., an XY plane) before assembly with the battery cell 251. Subsequently, at least a portion of the wing-shaped tape 320 may be provided such that some components are bent to surround at least a portion of the battery cell 251, after assembly with the battery cell 251. According to an embodiment, the first wing portion W1 and the second wing portion W2 of the wing-shaped tape 320 may maintain an unfolded state as illustrated in FIGS. 8 and 9, before the battery 250 is assembled to the electronic device 200, and may be bent to surround at least a portion of the battery cell 251 during the assembly process of the battery 250 to the electronic device 200.

According to an embodiment, the tape 300 of the disclosure is not necessarily limited to an embodiment where the double-sided tape 310 and the wing-shaped tape 320 are separated from each other. According to an embodiment, an integrated form where the double-sided tape 310 and the wing-shaped tape 320 are integrated is also applicable. For example, the tape 300 may include a fixing portion, and a wing portion that passes through a hole H formed on a third surface of the support member to surround at least a portion of the support member 220, and is disposed on a fourth surface stepped by a predetermined height from the first surface of the support member. However, for convenience of description, the following description will focus on the separate form of the double-sided tape 310 and the wing-shaped tape 320.

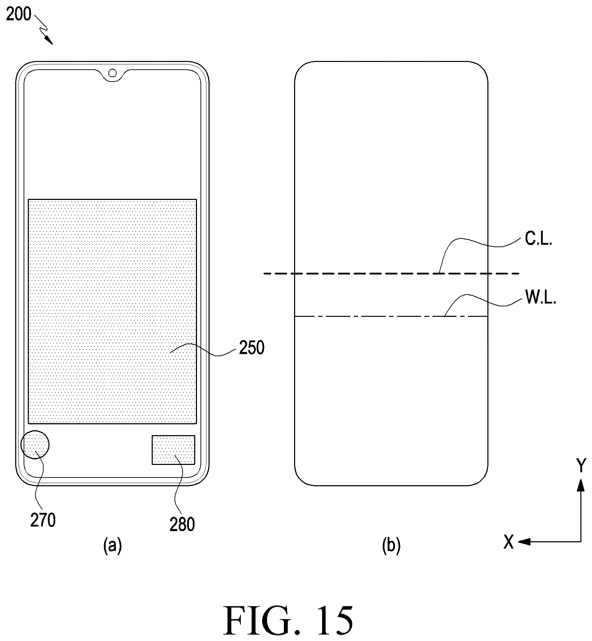

According to an embodiment, the tape 300 is not necessarily provided with only one wing-shaped tape 320. FIG. 9 illustrates that the wing-shaped tape 320 including the first wing portion W1 and the second wing portion W2 is provided at a position corresponding to a lower end of the battery 250, to which the disclosure is not limited. For example, one wing-shaped tape 320 may be disposed at each of the upper end and/or the lower end of the battery 250. The number or shape of wing-shaped tapes may vary, not being limited to the foregoing embodiment. The number or shape of wing-shaped tapes may be set considering factors such as the positions and/or weights of components included in the electronic device. For example, an embodiment considering the position and/or weight of the battery may be described later in the embodiment of FIG. 15.

With reference to FIGS. 10 to 12, the wing-shaped tape 320 will be described in more detail.

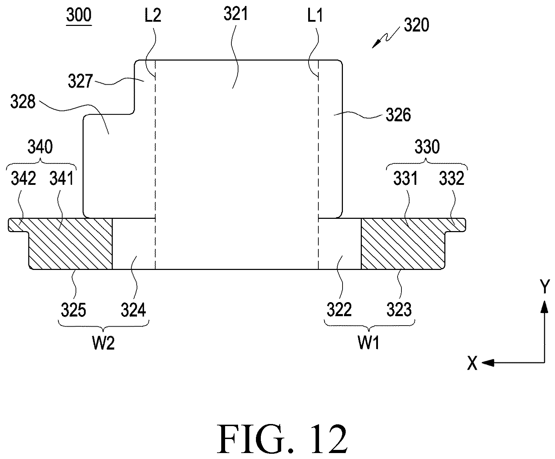

FIG. 10 is a diagram illustrating a battery to which a wing-shaped tape is attached according to an embodiment of the disclosure. FIG. 11 is a diagram illustrating a wing-shaped tape according to an embodiment of the disclosure. FIG. 12 is a diagram illustrating a wing-shaped tape to which a release liner is attached according to an embodiment of the disclosure.

According to an embodiment, the wing-shaped tape 320 may be referred to as a pull tab tape. Unlike the double-sided tape 310 used to attach the battery 250 to the support member 220, the wing-shaped tape 320 may be used for the purpose of detaching the battery 250 from the support member 220 and/or the electronic device 200. For example, when the battery 250 needs to be replaced due to discharge, damage, or the exhaustion of its service life, pulling the wing-shaped tape 320 may make it easy to remove the battery 250. However, it should be noted that in the disclosure, the wing-shaped tape 320 is not used simply to remove the battery 250, but may also be used for the purpose of preventing and/or reducing damage to the electronic device caused by the battery during a drop of the electronic device.

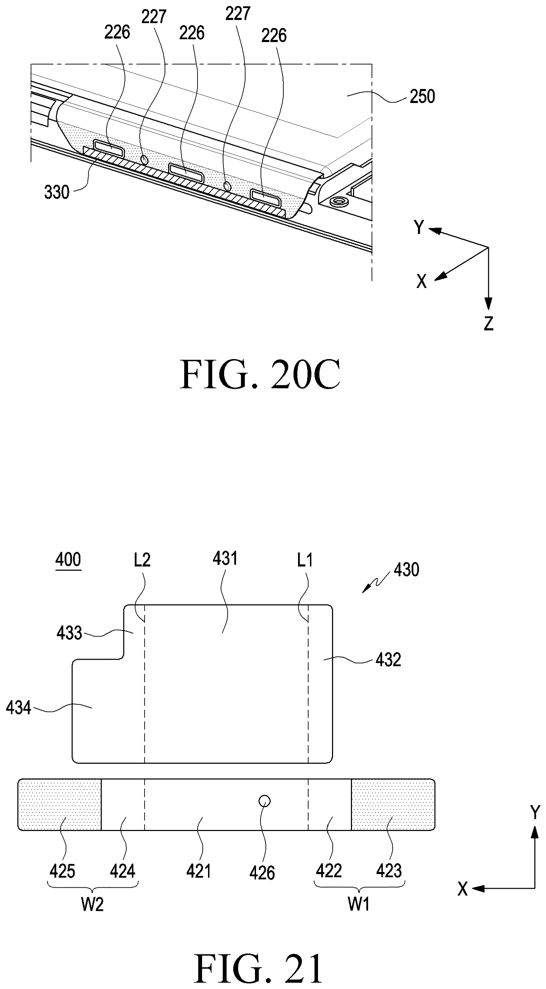

According to an embodiment, the tape 300 may include the base portion (321 in FIG. 11), the first wing portion W1, and the second wing portion W2. In an embodiment, the wing-shaped tape 320 may include the base portion 321, the first wing portion W1, and the second wing portion W2. According to an embodiment, the base portion 321 may correspond to the first surface 251a occupying a large area of the battery cell 251 that has a small thickness and large areas in the width direction (e.g., X-axis direction) and the length direction (e.g., Y-axis direction), and may be a portion that supports the first surface 251a while facing it. According to an embodiment, the base portion 321 may have an area substantially identical to the first surface 251a of the battery cell 251. Further, according to an embodiment, the base portion 321 may include an adhesive portion so as to be attached to the first surface 251a of the battery cell 251. Although the base portion 321 is shown as having a substantially identical area to the first surface 251a in the embodiment illustrated in FIGS. 10 and 11, the disclosure is not necessarily limited thereto. For example, it may be formed in a shape that corresponds to a specific area of the first surface 251a, like a base portion 421 in FIG. 21 to be described later.

Referring to FIGS. 10 and 11, the tape 300 of the disclosure may include a first extension portion 322 extending from the base portion 321 and facing a second surface 251b of the battery cell 251, and a second extension portion 324 extending from the base portion 321 and facing the third surface 251c of the battery cell 251. According to an embodiment, the wing-shaped tape 320 may include the first extension portion 322 extending from the base portion 321 and facing the second surface 251b of the battery cell 251, and the second extension portion 324 extending from the base portion 321 and facing the third surface 251c of the battery cell 251. Further, the tape 300 of the disclosure may include a first adhesive portion 323 extending from the first extension portion 322 and a second adhesive portion 325 extending from the second extension portion 324. According to an embodiment, the wing-shaped tape 320 may include the first adhesive portion 323 extending from the first extension portion 322 and the second adhesive portion 325 extending from the second extension portion 324. The first extension portion 322 and the first adhesive portion 323 may form the first wing portion W1, and the second extension portion 324 and the second adhesive portion 325 may form the second wing portion W2. However, the positions of the first adhesive portion 323 and the second adhesive portion 325 are not limited to the embodiment described above. For example, the first adhesive portion 323 and the second adhesive portion 325 may be formed on a portion or the entire area of the wing-shaped tape 320, and attached. Further, according to an embodiment, the first extension portion 322 and the second extension portion 324 may also be adhered to the second surface 251b and the third surface 251c of the battery cell 251 by including at least some adhesive material, like the first adhesive portion 323 and the second adhesive portion 325.

According to an embodiment, the tape 300 of the disclosure may include a third extension portion 326 extending from the base portion 321 and facing the second surface 251b of the battery cell 251, and a fourth extension portion 327 extending from the base portion 321 and facing the third surface 251c of the battery cell 251. According to an embodiment, the wing-shaped tape 320 may include the third extension portion 326 extending from the base portion 321 and facing the second surface 251b of the battery cell 251, and the fourth extension portion 327 extending from the base portion 321 and facing the third surface 251c of the battery cell 251. Further, the tape 300 of the disclosure may include a handle portion 328 extending from the third extension portion 326 or the fourth extension portion 327. According to an embodiment, the wing-shaped tape 320 may include the handle portion 328 extending from the third extension portion 326 or the fourth extension portion 327. In FIG. 10, the handle portion 328 is shown as being formed on the third extension portion 326.

Referring to FIG. 11, the base portion 321 may be distinguished from the first extension portion 322 and the third extension portion 326 by a first folding line L1, and distinguished from the second extension portion 324 and the fourth extension portion 327 by a second folding line L2. The first extension portion 322 and the second extension portion 324 may be bent during the process of assembling the battery 250 to the electronic device 200, as described later, and may be configured to pass through the hole H prepared in the support member 220. Unlike this, the third extension portion 326 and the fourth extension portion 327 may be bent during the process of attaching the wing-shaped tape 320 to the battery cell 251 to surround the battery cell 251. According to an embodiment, the third extension portion 326 and the fourth extension portion 327 may surround the second surface 251b and the third surface 251c of the battery cell 251 during the process of attaching the wing-shaped tape 320 to the battery cell 251, and further, may be formed to cover at least a portion of the fourth surface 251d of the battery cell 251.

Referring again to FIG. 10, according to an embodiment, with the wing-shaped tape 320 to the battery cell 251, the handle portion 328 may cover at least a portion of the fourth surface 251d of the battery cell 251. Herein, the handle portion 328 may be disposed without being attached to the fourth surface 251d of the battery cell 251.

Referring to FIG. 12, the wing-shaped tape 320 may be assembled to the battery 250, with release liners 330 and 340 attached to the first adhesive portion 323 and the second adhesive portion 325, respectively. According to an embodiment, the release liners 330 and 340 may include portions 331 and 341 having areas corresponding to the first adhesive portion 323 and the second adhesive portion 325, respectively, and handle portions 332 and 342. When the battery 250 is assembled to (is seated in) the electronic device 200, the release liners 330 and 340 may remain attached to the first adhesive portion 323 and the second adhesive portion 325. After the battery 250 is assembled (seated) in the electronic device 200, the first adhesive portion 323 and the second adhesive portion 325 may be exposed by pulling and peeling off the handle portions 332 and 342 of the release liners 330 and 340. Then, the first adhesive portion 323 and the second adhesive portion 325 may be folded and disposed and/or attached onto the fourth surface 251d of the battery cell 251.

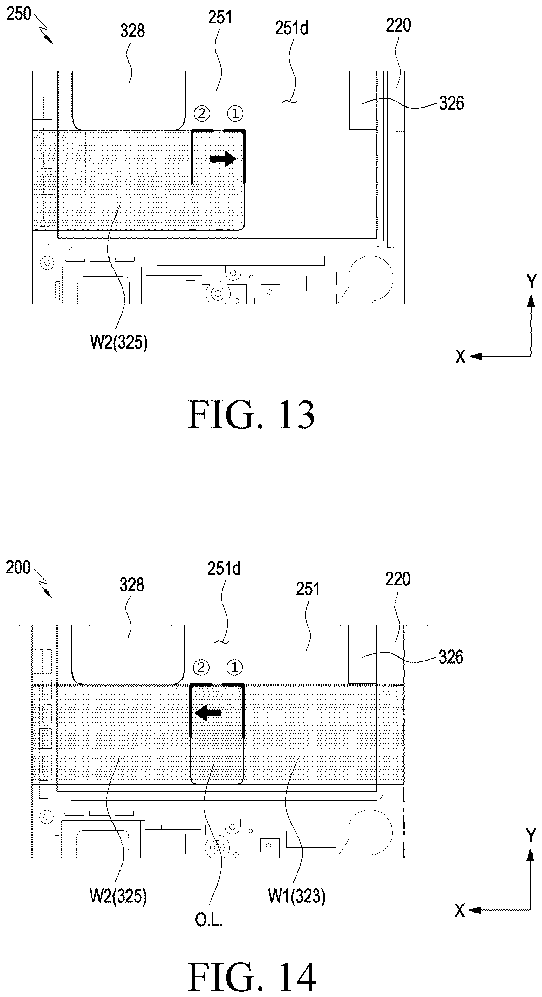

FIG. 13 is a diagram illustrating a wing-shaped tape attached to a battery according to an embodiment of the disclosure. FIG. 14 is a diagram illustrating a wing-shaped tape attached to a battery according to an embodiment of the disclosure.

FIG. 13 may illustrate a state where the second wing portion W2 of the wing-shaped tape 320 is folded and attached onto the fourth surface 251d of the battery cell 251. FIG. 14 may illustrate a state where not only the second wing portion W2 but also the first wing portion W1 of the wing-shaped tape 320 is folded and attached onto the fourth surface 251d of the battery cell 251.

For example, a guide line may exist on the battery cell 251 or the first wing portion W1 and/or the second wing portion W2, visibly or invisibly indicating attachment position of the first wing portion W1 and the second wing portion W2. Referring to FIG. 13, the second wing portion W2 may be disposed on the fourth surface 251d of the battery cell 251 in the folded state, and its end may be located on a first guide line ①. Referring to FIG. 14, the first wing portion W1 may be disposed on the fourth surface 251d of the battery cell 251 in the folded state, and its end may be located on a second guide line ②. According to an embodiment, when the wing-shaped tape is attached to the battery, the first wing portion W1 and the second wing portion W2 may include an overlap area O.L. where they are at least partially overlap.

The embodiment of FIGS. 13 and 14 does not necessarily limit the assembly sequence of the first wing portion W1 and the second wing portion W2. Although FIGS. 13 and 14 illustrate that the second wing portion W2 is first attached onto the fourth surface 251d of the battery cell 251, a reverse embodiment is also possible.

FIG. 15 is a diagram illustrating the position of the center of gravity of an electronic device based on the arrangement of various components according to an embodiment of the disclosure.

According to an embodiment, the electronic device 200 may include a plurality of components, and its center of gravity may be variously set according to the arrangement of the plurality of components. For example, the electronic device 200 may include a driving module 270 (e.g., a motor) or a speaker module 280, in addition to the battery 250 occupying a significant space and having a significant weight inside the electronic device 200. FIG. 15(a) is a diagram illustrating approximate positions of internal electronic components, for example, as the battery 250, the driving module 270, and the speaker module 280. FIG. 15(b) is a diagram illustrating a center line C.L. passing through the center of the electronic device 200 and a weight line W.L. along which the center of gravity of the electronic device 200 passes. Referring to FIG. 15(a), when components with relatively large weights compared to other components, such as the battery 250, the driving module 270, and the speaker module 280, are arranged biased toward one side (e.g., a lower end portion of FIG. 15(a)) with respect to the center line C.L. passing through the center of the electronic device 200, the position of the weight line W.L. along which the center of gravity of the electronic device 200 passes may be formed at an eccentric position with respect to the center line C.L. of the electronic device 200.

According to an embodiment, considering the position of the weight line W.L. along which the center of gravity of the electronic device 200 passes, the first wing portion W1 and the second wing portion W2 of the wing-shaped tape 320 may be formed at positions eccentric to one side with respect to the center of the battery 250.

The tape 300 may have the first wing portion W1 and the second wing portion W2 extending from one end of the base portion. According to an embodiment, the wing-shaped tape 320 may have the first extension portion 322 and the second extension portion 324 extending from one end of the base portion. For example, referring to FIG. 10 and FIG. 15 together, the one end of the base portion from which the first wing portion W1 and the second wing portion W2 extend may correspond to a portion adjacent to one end 251e of the battery cell 251. The sizes and/or positions of the first wing portion W1 and the second wing portion W2 of the wing-shaped tape 320 may be set considering the center of gravity of the battery 250 and the electronic device 200 including the battery 250, and a vulnerable position of the electronic device 200 to damage, when dropped, based on the center of gravity.

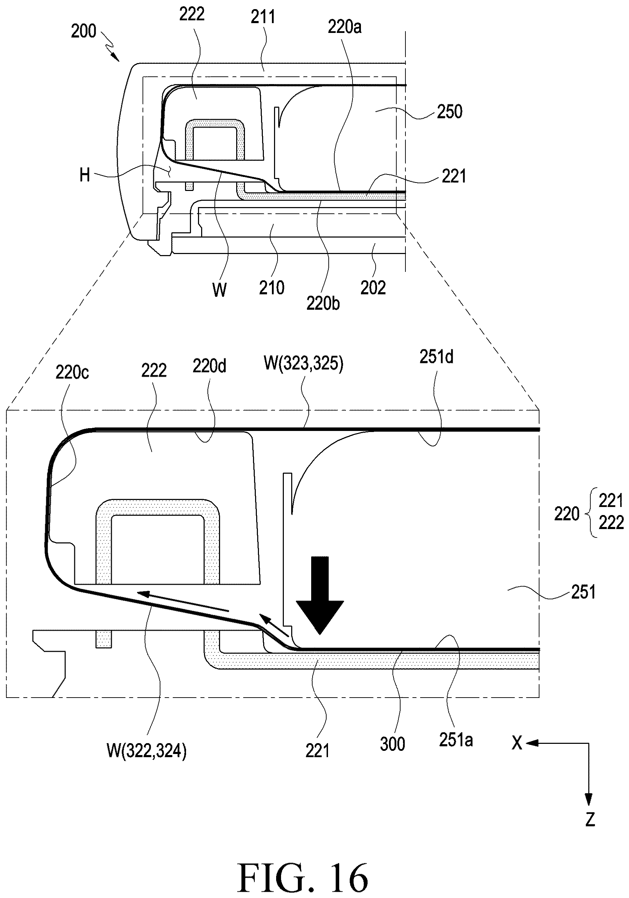

FIG. 16 is a cross-sectional view illustrating an electronic device according to an embodiment of the disclosure.

FIG. 16 may provide an enlarged view illustrating an arrangement relationship among the battery 250, the tape 320 attached to the battery 250, and the support member 220 supporting the battery 250, along with a cross-section of the electronic device.

The electronic device 200 may include the support member 220 that includes the first surface 220a, the second surface 220b facing in an opposite direction to the first surface 220a, and a third surface 220c different from the first surface 220a and the second surface 220b. The battery 250 may be seated on the first surface 220a of the support member 220. According to an embodiment, the third surface 220c may be a surface facing the side bezel structure 212 and/or the rear plate 211 of the electronic device 200. According to an embodiment, the third surface 220c may be substantially perpendicular to the first surface 220a and the second surface 220b. The support member 220 may further include a fourth surface 220d. The fourth surface 220d may correspond to a surface stepped by a predetermined height from the first surface 220a. According to an embodiment, the fourth surface 220d may be formed substantially parallel to the first surface 220a.

In the case where the support member 220 includes two different materials, for example, it is divided into the first portion 221 including a first material (e.g., a metallic material) and the second portion 222 including a second material (e.g., a non-metallic material), the first surface 220a and the second surface 220b may correspond to both surfaces of the first portion 221 facing in opposite directions, respectively, and the third surface 220c and the fourth surface 220d may correspond to surfaces included in the second portion 222. However, the disclosure is not necessarily limited thereto. As described before in the embodiment of FIGS. 6 and 7, the support member 220 produced by the die casting, full front, full metal, or ruggedize manufacturing method may also be applied as an example of the support member 220, and accordingly, the definition of the first portion 221 and the second portion 222 may also be variously applied depending one embodiments. For convenience in the disclosure, the support member 220, the battery 250, and the tape 300 attached to the battery 250 of the disclosure will be described focusing on the embodiment of FIG. 16 where the first portion 221 is formed as a plate including a metallic material, and the second portion 222 is formed as an injection molded structure including an injection molded material. According to the disclosure, a hole H may be formed in the third surface 220c, in a direction substantially perpendicular or inclined to a direction in which the battery 250 is seated on the first surface 220a of the support member 220. The hole H may be formed by processing it from the exterior of the support member 220 using a machine (e.g., a drill) or by using a mold that includes a slide core. In FIG. 16, the hole H is shown as being substantially perpendicular to the third surface 220c of the support member 220, to which the disclosure is not necessarily limited. According to an embodiment, the hole H may be formed obliquely with respect to the third surface 220c of the support member 220, for example, in a direction parallel to a direction in which the tape 300 is pulled.

With the battery 250 disposed on the first surface 220a of the support member, the tape 300 of the disclosure may pass through the hole H formed on the third surface 220c of the support member 220 and surround at least a portion of the support member 220. At least a portion of the tape 300 that is disposed on the hole H after passing through the hole H may be an extension portion (e.g., the first extension portion 322 or the second extension portion 324) included in a wing portion (e.g., the first wing portion W1 and/or the second wing portion W2). Further, at least a portion of the tape 300 may be disposed on the fourth surface 220d stepped by a predetermined height from the first surface of the support member. Herein, at least a portion of the tape 300 disposed on the fourth surface 220d may be an adhesive portion (e.g., the first adhesive portion 323 or the second adhesive portion 324) included in a wing portion (e.g., the first wing portion W1 and/or the second wing portion W2). Therefore, the tape 300 may be attached to the fourth surface 220d by the adhesive portion (e.g., the first adhesive portion 323 or the second adhesive portion 324). However, the disclosure is not necessarily limited thereto, and according to an embodiment, the adhesive portion (e.g., the first adhesive portion 323 or the second adhesive portion 324) included in the wing portion (e.g., the first wing portion W1 and/or the second wing portion W2) may be disposed on the hole H. Further, according to an embodiment, the extension portion (e.g., the first extension portion 322 or the second extension portion 324) included in the wing portion (e.g., the first wing portion W1 and/or the second wing portion W2) may be disposed on the fourth surface 220d.

Referring to FIG. 16, while being tautly pulled to form tension in a direction opposite to the direction in which the battery 250 is seated, the wing portion (e.g., the first wing portion W1 and/or the second wing portion W2) of the tape 320 may pass through the hole H and be attached to the fourth surface 220d. The use of the tape 320 including the wing portion may reduce and/or prevent the deflection of the display 210 or the damage to the front plate 202 (e.g., the window) resulting from the drop inertia of the battery 250 when the electronic device 200 is dropped. According to an embodiment, the tape 320 may also be formed such that the wing portion (e.g., the first wing portion W1 and/or the second wing portion W2) is attached to one surface of the battery 250 (e.g., the fourth surface 251d of the battery cell 251) after passing over the fourth surface 220D of the support member 220.

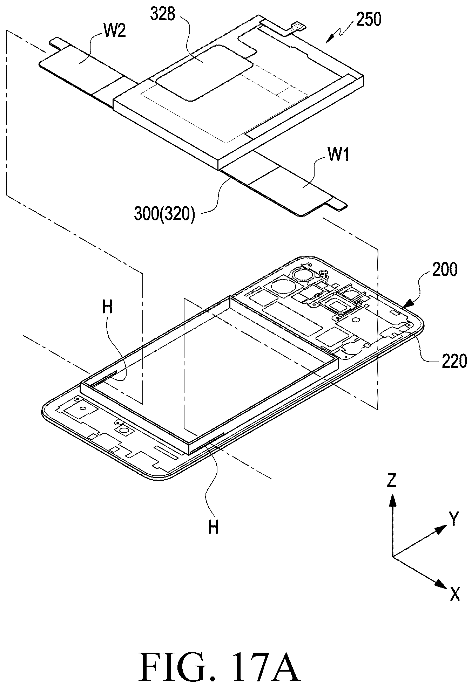

FIGS. 17A to 17D are diagrams illustrating the assembly of a battery to an electronic device according to an embodiment of the disclosure.

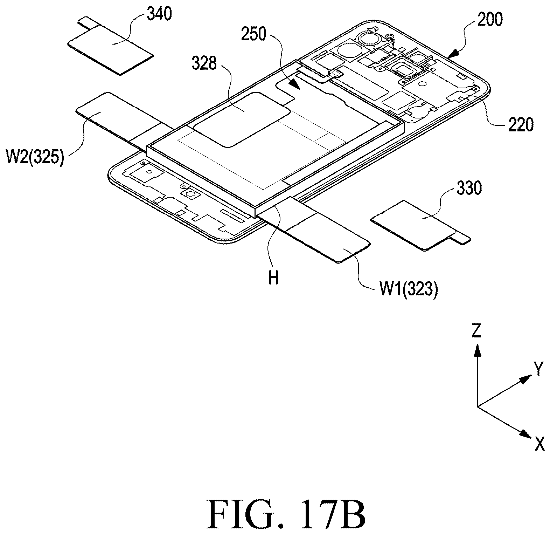

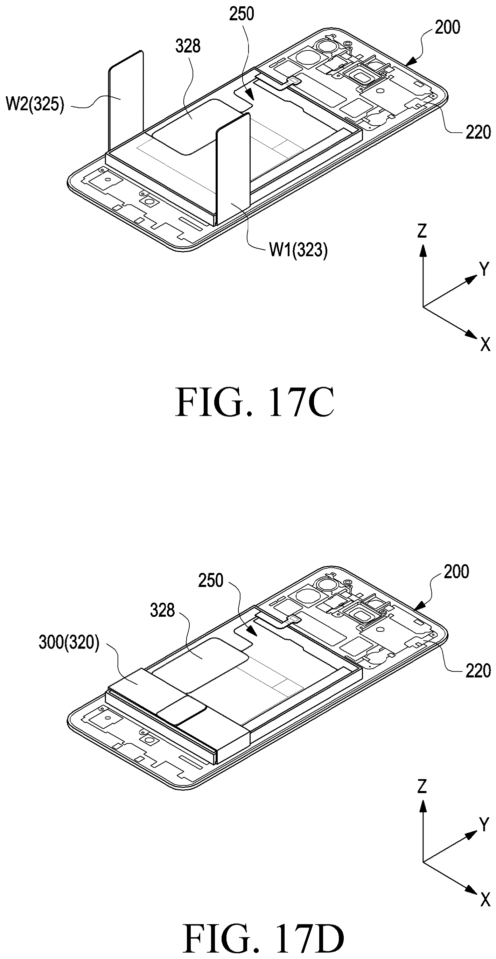

FIGS. 17A to 17D may illustrate a method for assembling the wing-shaped tape 320 included in the battery 250, when the battery 250 is seated in the electronic device 200. Referring to FIG. 17A, according to an embodiment, when the battery 250 is seated in the electronic device 200, the tape 300 (e.g., the wing-shaped tape 320) may be configured such that the wing portions W1 and W2 are inserted into holes H formed in the support member 220. Referring to FIG. 17B, according to an embodiment, the wing portions W1 and W2 of the wing-shaped tape 320 may initially have the release liners 330, 340 attached thereto. When the wing portions W1 and W2 are inserted into the holes H, the release liners 330 and 340 may be removed. At this time, the adhesive portions (the first adhesive portion 323 and the second adhesive portion 325) of the wing portions W1 and W2 may be exposed to be visible from the outside. When the wing portions W1 and W2 are inserted into the holes H, they are located outside the boundary of the electronic device 200. Accordingly, the wing portions W1 and W2 may be folded toward the battery 250 as illustrated in FIG. 17C. According to an embodiment, as illustrated in FIG. 17D, the wing portions W1 and W2 may be attached to one surface of the battery 250 (e.g., the fourth surface 251d of the battery cell 251). Further, according to an embodiment, the tape 300 (e.g., the wing-shaped tape 320) may be formed such that the wing portions W1 and W2 at least partially overlap each other, allowing the battery 250 to maintain its position more firmly without free movement.

When the battery 250 is to be detached from the electronic device 200, the battery 250 may be easily removed by simply cutting the wing portions W1 and W2 and pulling the tape 300 (e.g., the wing-shaped tape 320) along with the battery 250 using the handle portion 328.

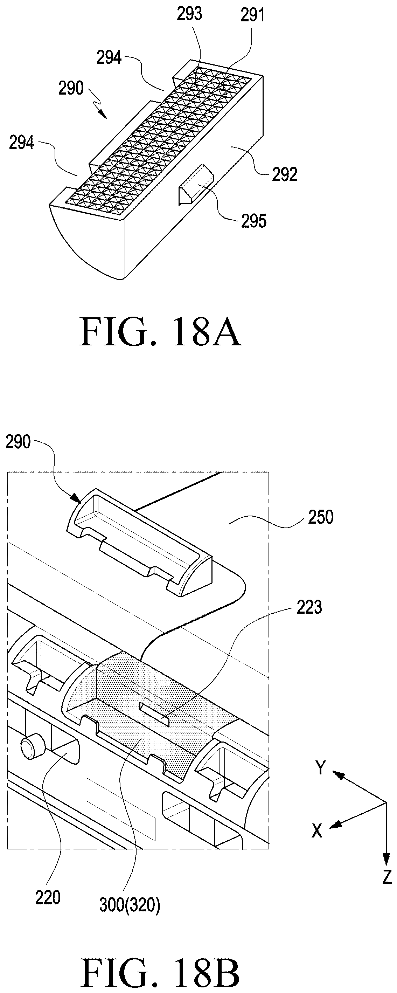

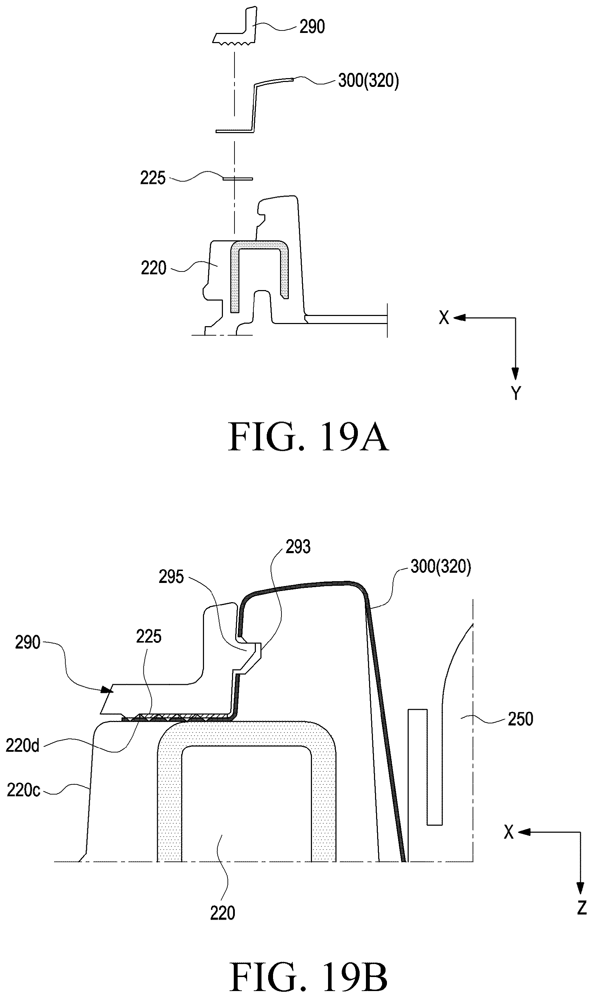

FIGS. 18A to 18C are perspective views illustrating a fixing member for fixing a tape to a support member according to an embodiment of the disclosure. FIGS. 19A and 19B are cross-sectional views illustrating a fixing member for fixing a tape to a support member according to an embodiment of the disclosure.

According to an embodiment, the electronic device 200 may include a fixing member 290 for fixing the tape 300 (e.g., the wing-shaped tape 320) to the support member 220. According to an embodiment, the fixing member 290 may be disclosed, which is provided additionally or alternatively to the hole H in the embodiment illustrated in FIGS. 16 and 17. For example, the electronic device 200 including the hole H illustrated in FIGS. 16 and 17, and the tape 300 (e.g., the wing-shaped tape 320) disposed on the fourth surface 220d of the support member 220 after passing through the hole H may further include the fixing member 290 which allows the tape 300 (e.g., the wing-shaped tape 320) to be supported more firmly by the support member 220. Alternatively, as illustrated in the embodiment of FIGS. 18A to 19B, the tape 300 (e.g., the wing-shaped tape 320) may be fixed using only the fixing member 290, without the hole H formed on the third surface 220c of the support member 220.

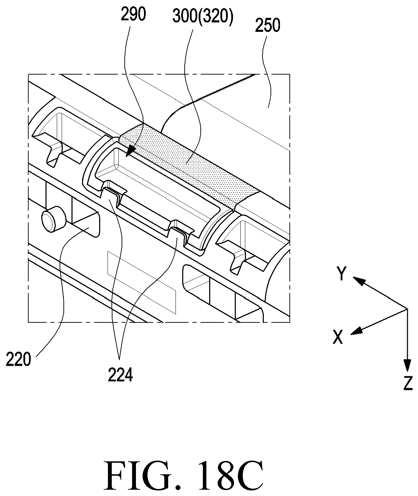

Referring to FIG. 18A, the fixing member 290 may include at least two surfaces 291 and 292, and an uneven structure 293 and/or a hook structure 295 may be formed on the at least two surfaces, respectively. Referring to FIG. 18B, in a state where the tape 300 (e.g., the wing-shaped tape 320) is disposed to surround at least a portion of the support member 220, the fixing member 290 may be assembled at a position where the support member 220 and the tape 300 (e.g., the wing-shaped tape 320) are stacked, thereby preventing the tape 300 (e.g., wing-shaped tape 320) from moving. According to an embodiment, the support member 220 may be provided with at least one groove 223. The hook structure 295 of the fixing member 290 may be coupled to the groove 223. Further, referring to FIG. 18C, the fixing member 290 may be provided with at least one recess 294, and at least one anti-slip structure 224 formed on the support member 220 may be fitted into the at least one recess 294. The fixing member 290 may restrict the movement of the fixing member 290 and the tape 300 (e.g., the wing-shaped tape 320) disposed on the rear surface of the fixing member 290 in a specific direction (e.g., the height direction) by the fastening of the hook structure 295 and the at least one groove 223 formed on the support member 220. Additionally, the fixing member 290 may restrict the movement of the fixing member 290 and the tape 300 (e.g., the wing-shaped tape 320) disposed on the rear surface of the fixing member 290 in a specific direction (e.g., the height direction) by the fastening of the anti-slip structure 224 formed on the support member 220 and the at least one recess 294.

Referring to FIGS. 19A and 19B together, according to an embodiment, the electronic device 200 may further include an elastic member 225 (e.g., a sponge). According to an embodiment, the elastic member 225 (e.g., a sponge) may further include the elastic member 225 (e.g., a sponge) between the tape 200 (e.g., the wing-shaped tape 320) and the support member 220, and the position of the tape 300 (e.g., the wing-shaped tape 320) may be more firmly fixed by disposing the elastic member 225 (e.g., a sponge) to overlap the surface of the fixing member 290 on which the uneven structure 293 is formed.

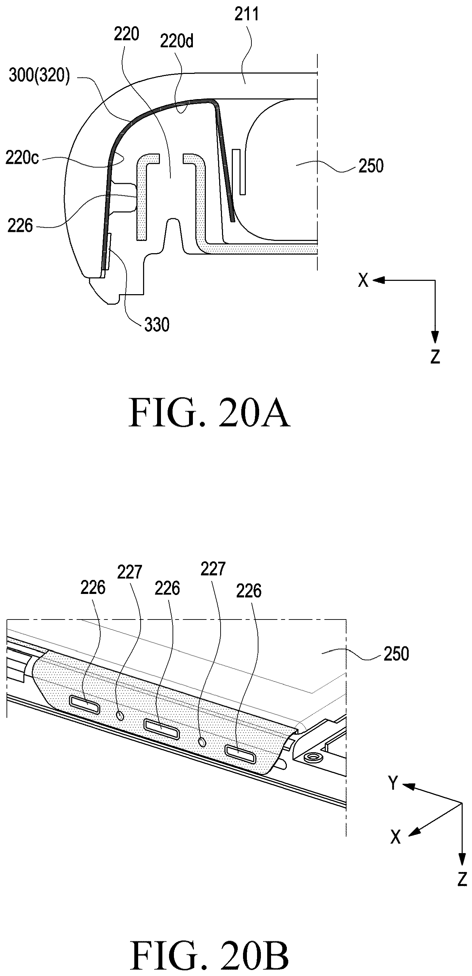

FIGS. 20A to 20C are perspective views illustrating a cover for fixing a tape to a support member according to an embodiment of the disclosure.

Referring to FIGS. 20A to 20C, the electronic device 200 may include a cover (e.g., the rear plate 211) for fixing the tape 300 (e.g., the wing-shaped tape 320) to the support member 220.

The electronic device 200 may include the cover for fixing the tape 300 (e.g., the wing-shaped tape 320) to the support member 220. Herein, the cover may be the rear plate 211 and/or a side plate, rather than a separately provided component like the fixing member 290 in the embodiment of FIGS. 18A to 19B described before. Referring to FIG. 20A, an embodiment is shown in which the rear plate 211 and the side plate are integrated with each other, and for convenience, the following description will focus on the rear plate 211 integrated with the side plate.

According to an embodiment, the cover (e.g., the rear plate 211) may be disclosed, which is provided additionally or alternatively to the hole H in the embodiment illustrated in FIGS. 16 and 17. For example, the electronic device including the hole H illustrated in FIGS. 16 and 17 and the tape 300 (e.g., the wing-shaped tape 320) which is disposed on the fourth surface 220d of the support member 220 after passing through the hole H may further include the cover (e.g., the rear plate 211) the fixing member 290 to allow the tape 300 (e.g., the wing-shaped tape 320) to be supported more firmly by the support member 220. Alternatively, as illustrated in the embodiment of FIGS. 20A to 20C, the tape 300 (e.g., the wing-shaped tape 320) may be fixed using only the cover (e.g., the rear plate 211) without forming the hole H on the third surface 220c of the support member 220.

Referring to FIG. 20A, the cover (e.g., the rear plate 211) may be configured to surround the third surface 220c and the fourth surface 220d of the support member 220. As illustrated in FIGS. 20B and 20C, the tape 300 (e.g., the wing-shaped tape 320) is disposed on the fourth surface 220d of the support member 220 and then extends to the third surface 220c. Accordingly, it is possible to realize a wing portion with a greater wing width WW, compared to the embodiment where the tape 300 (e.g., the wing-shaped tape 320) passes through the hole H formed on the third surface 220c of the support member 220.

According to an embodiment, the support member 220 may include at least one groove 226 to which an uneven structure (not shown) formed on the inner surface of the cover (e.g., the rear plate 211) is fastened.

According to an embodiment, a guide portion 227 may be provided on the support member 220, as a component for ensuring that the position of the tape 300 (e.g., the wing-shaped tape 320) is firmly maintained with respect to the support member 220.

Further, according to an embodiment, the electronic device 200 may further include a double-sided tape 330 to allow the tape 300 (e.g., the wing-shaped tape 320) based on the embodiment illustrated in FIG. 20 to be attached to the support member 220.

FIG. 21 is a diagram illustrating a separated wing-shaped tape according to an embodiment of the disclosure.

According to an embodiment of the disclosure, a tape 400 may include a base portion 421, a first wing portion W1, and a second wing portion W2. The tape illustrated in FIG. 21 may include a wing-shaped tape 420 and a support tape 430. According to an embodiment, the wing-shaped tape 420 may include a first base portion 421, the first wing portion W1, and the second wing portion W2. According to an embodiment, the first wing portion W1 may include a first extension portion 422 and a first adhesive member 423, and the second wing portion W2 may include a second extension portion 424 and a second adhesive member 425. According to an embodiment, the support tape 430 may include a second base portion 431, a third extension portion 432, and a fourth extension portion 433. Further, the support tape 430 may include a handle portion 434. However, the arrangement and positions of the first adhesive member 423 and the second adhesive member 425 are not limited to the embodiment described above. For example, the first adhesive member 423 and the second adhesive member 425 may be formed and attached to a portion or the entire area of the wing-shaped tape 420.

In the embodiment illustrated inFIG. 21, a wing-shaped tape structure where the wing-shaped tape 420 and the support tape 430 are separate from each other may be disclosed. The wing-shaped tape 420 may be coupled to one surface of the battery 250 along with the support tape 430 to support the battery 250. However, because the wing-shaped tape 420 is a separate configuration from the support tape 430, the assembly and/or disassembly operation of the wing-shaped tape 420 for the battery 250 may be performed separately from the support tape 430. For example, the wing-shaped tape 420 illustrated in FIG. 21 may be assembled to the electronic device along with the battery 250, while seated in a mold. As a mold guide hole 426 is formed in the first base portion 421 of the wing-shaped tape 420, the assembly and/or disassembly operation of the wing-shaped tape 420 on the battery 250 may be performed more smoothly.

In the embodiment of FIG. 21, the wing-shaped tape 420 is shown as being disposed under the support tape 430, to which the disclosure is not necessarily limited. For example, the wing-shaped tape 420 may be disposed in various positions considering various factors such as the position and/or center of gravity of the electronic device to which the tape 400 is attached and/or a component (e.g., the battery 250) disposed inside the electronic device. For example, the wing-shaped tape 420 may be disposed on the support tape 430. Further, for example, wing-shaped tapes 420 may be disposed above and below the support member 430, respectively. Various other embodiments are applicable.

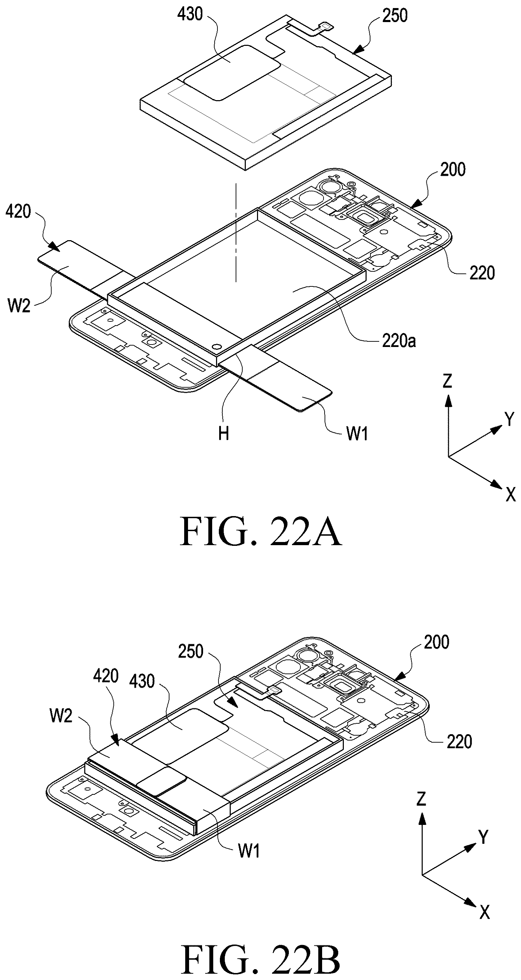

FIGS. 22A and 22B are diagrams the assembly of a battery to an electronic device according to an embodiment of the disclosure.

FIGS. 22A and 22B may illustrate a method for assembling the wing-shaped tape 420 included in the battery 250, when the battery 250 is seated in the electronic device 200. Referring to FIG. 22A, according to an embodiment, when the battery 250 is seated in the electronic device 200, the tape 400 (e.g., the wing-shaped tape 420) may be configured such that the wing portions W1 and W2 are inserted into holes H formed in the support member 220. Since the tape 400 has a wing-shaped tape structure where the wing-shaped tape 420 and the support tape 430 are separate from each other, the support tape 430 may be attached separately from the wing-shaped tape 420. FIG. 22A illustrates that the support tape 430 is attached after the wing-shaped tape 420 is attached, to which the disclosure is not necessarily limited, and the reverse is also possible.

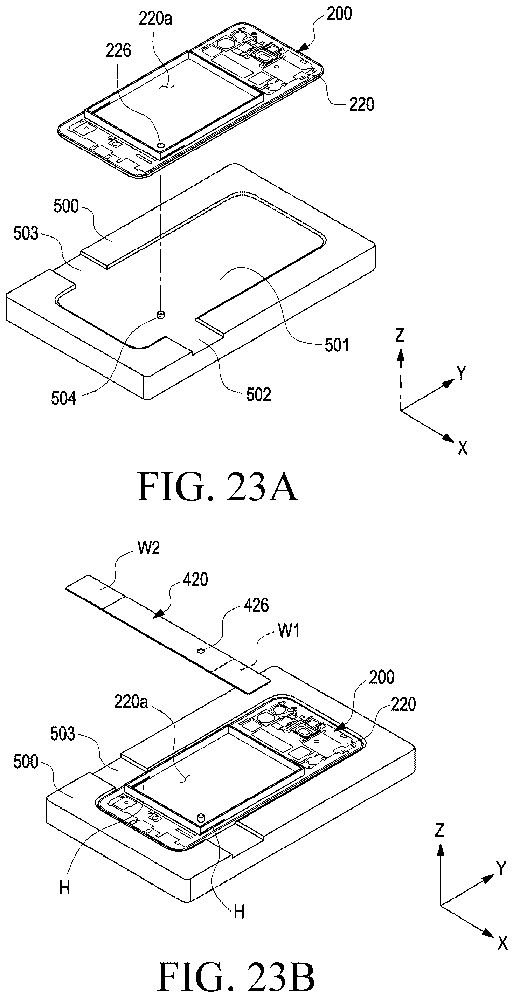

FIGS. 23A to 23E are diagrams illustrating the assembly of a wing-shaped tape to an electronic device according to an embodiment of the disclosure.

Referring to FIG. 23A, a jig 500 may be used to assemble the wing-shaped tape 420 to the electronic device 200. A first seating portion 501 may be formed on the jig 500 to guide the position of the electronic device 200. Further, a second seating portion 502 and a third seating portion 503 may be formed on the jig 500 to guide the wing-shaped tape 420.

Referring to FIGS. 23A and 23B together, the second seating portion 502 and the third seating portion 503 may be provided to guide the first wing portion W1 and the second wing portion W2 of the wing-shaped tape 420, respectively. The positions of the second seating portion 502 and the third seating portion 503 may be set considering an intended attachment position of the wing-shaped tape 420. According to an embodiment, a guide pin 504 may be formed on the jig 500 to align the position of the wing-shaped tape 420 during the assembly process, and the guide hole 426 corresponding to the guide pin 504 may be formed in the wing-shaped tape 420.

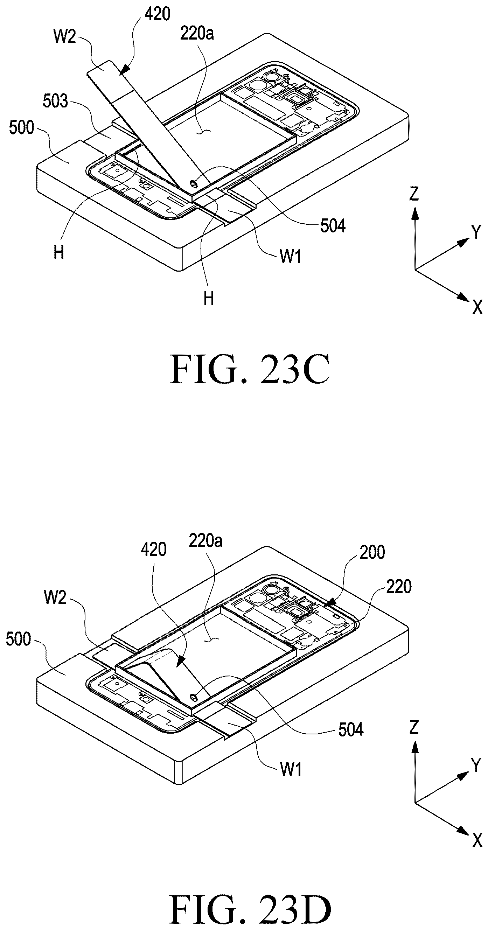

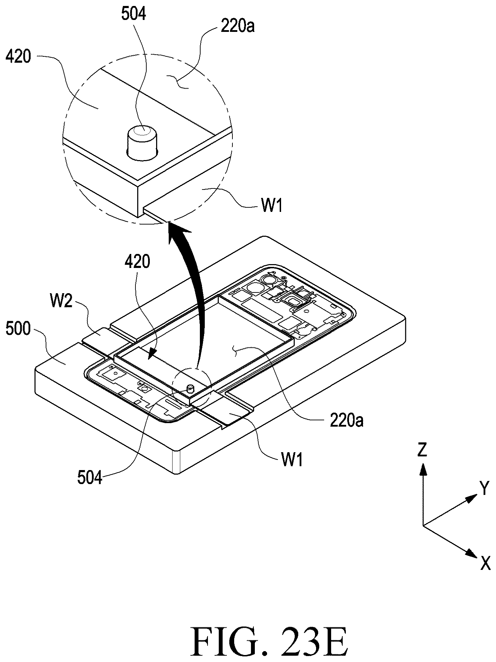

First, referring to FIGS. 23A and 23B, in a state where the electronic device 200 is first seated in the first seating portion 501 of the jig 500, the wing-shaped tape 420 may be located to correspond to the second seating portion 502 and the third seating portion 503. Referring to FIG. 23C, one (e.g., the first wing portion W1) of the wing portions of the wing-shaped tape 420 may be inserted into a hole H formed in the support member 220. Then, referring to FIG. 23D, the other wing portion (e.g., the second wing portion W2) of the wing-shaped tape 420 may be inserted into a hole H formed in the support member 220. In the assembly operation of FIGS. 23C and 23D, as the guide pin 504 is inserted into the guide hole 426 formed in the wing-shaped tape 420, the wing-shaped tape 420 may be seated in the electronic device 200 as illustrated in FIG. 23E.

The embodiment of assembling the wing-shaped tape 420 for which FIGS. 23A to 23E are referred to may be applied adaptively to a method for assembling the wing-shaped tape 320 described before.

Since the battery and the electronic device 101 or 200 including the battery according to the disclosure include the tape 300 according to various embodiments described above, when the electronic device 101 or 200 is dropped, damage to internal components of the electronic device 101 or 200 caused by the drop inertia of the battery 250 may be prevented and/or reduced effectively.

The effects obtainable from the disclosure are not limited to those mentioned above, and other unmentioned effects will be clearly understood by those skilled in the art from the above description of embodiment(s).

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1^{st}" and "2^{nd}", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to an embodiment of the disclosure, the electronic device 101 or 200 may be provided. The electronic device may include the housing 201, the support member 220 which includes the first surface 220a, the second surface 220b facing in a direction opposite to the first surface, and the third surface 220c different from the first surface 220a and the second surface 220b, and is accommodated in the housing, and the battery 250 disposed on the first surface 220a of the support member, and including the battery cell 251 and the tape 300 surrounding at least a portion of the battery cell 251. In a state in which the battery 250 is disposed on the first surface 220a of the support member, at least a portion of the tape 300 may surround the support member 220 and be disposed on the fourth surface 220d stepped by a predetermined height from the first surface of the support member 200.

According to an embodiment, the tape 300 may include the double-sided tape 310, and the wing-shaped tape 320 disposed on the fourth surface parallel to the first surface of the support member and passing through a hole formed on the third surface of the support member to surround at least a portion of the support member 220.

According to an embodiment, the double-sided tape 310 and the wing-shaped tape 320 may be disposed to at least partially overlap each other.

According to an embodiment, the tape 300 may be formed to surround the battery cell 251 in at least three different directions.

According to an embodiment, the tape 300 may include a base portion corresponding to the first surface 251a of the battery cell 251, the first extension portion 322 extending from the base portion and configured to face the second surface 251b of the battery cell 251, and the second extension portion 324 extending from the base portion and configured to face the third surface 251c of the battery cell 251.

According to an embodiment, the tape 300 may include the first adhesive portion 323 extending from the first extension portion, and the second adhesive portion 325 extending from the second extension portion.

According to an embodiment, the first extension portion and the second extension portion of the tape 300 may be extended from one end of the base portion.

According to an embodiment, the first extension portion and the second extension portion of the tape 300 may be disposed at a position eccentric to one side with respect to a virtual line passing through a center of the electronic device and parallel to a width direction of the electronic device.

According to an embodiment, the tape 300 may include the third extension portion 326 extending from the base portion and facing the second surface 251b of the battery cell 251, and the fourth extension portion 327 extending from the base portion and facing the third surface 251c of the battery cell 251.

According to an embodiment, the tape 300 may include the handle portion 328 extending from the third extension portion or the fourth extension portion.

According to an embodiment, the electronic device may include a fixing member configured to fix the tape to the support member.

According to an embodiment, the electronic device may include a cover configured to fix the tape to the support member.

According to an embodiment, the support member 220 may include a first portion including a first material and a second portion including a second material different from the first material, and the battery may be disposed on the second portion of the support member

According to an embodiment, the first portion may include a non-metallic material, and the second portion may include a metallic material.

According to an embodiment, the tape 300 may include a fixing portion, and a wing portion, wherein at least a portion of the wing portion passes through the hole formed on the third surface of the support member to surround at least a portion of the support member 220 and at least a portion of the wing portion is disposed on the fourth surface stepped by the predetermined height from the first surface of the support member.

According to an embodiment of the disclosure, the electronic device 101 or 200 may be provided. The electronic device may include the housing 201, the support member 220 which includes the first portion 221 including the first surface 220a and the second surface 220b facing in a direction opposite to the first surface, and the second portion 222 including the third surface 220c different from the first surface 220a and the second surface 220b, and the battery 250 disposed on the first surface 220a of the first portion of the support member, and including the battery cell 251 and the tape 300 surrounding at least a portion of the battery cell 251. The tape may include the double-sided tape 310, and the wing-shaped tape 320 which at least partially overlaps the double-sided tape, at least partially passes through a hole formed on the third surface of the support member to surround at least a portion of the support member 220, and is at least partially disposed on the fourth surface 220d stepped by a predetermined height from the first surface of the support member.

According to an embodiment, the tape 300 may be formed to surround the battery cell 251 in at least three different directions.

According to an embodiment, the tape 300 may include a base portion corresponding to the first surface 251a of the battery cell 251, the first extension portion 322 extending from the base portion and facing the second surface 251b of the battery cell 251, and the second extension portion 324 extending from the base portion and facing the third surface 251c of the battery cell 251.

According to an embodiment, the tape 300 may include the first adhesive portion 323 extending from the first extension portion, and the second adhesive portion 325 extending from the second extension portion.

According to an embodiment, the first extension portion and the second extension portion of the tape 300 may be disposed at a position eccentric to one side with respect to a virtual line passing through a center of the electronic device and parallel to a width direction of the electronic device.

Although the disclosure has been illustrated and described with reference to exemplary embodiments, it should be understood that the exemplary embodiments are for illustration and are not intended to limit the disclosure. It will be obvious to those skilled in the art that various changes in form and detail may be made to the configuration without departing from the overall scope of the disclosure, including the appended claims and their equivalents.

## Claims

1. An electronic device (101; 200), comprising:
a housing (201);
a support member (220) including a first surface (220a), a second surface (220b) facing in a direction opposite to the first surface, and a third surface (220c) different from the first surface (220a) and the second surface (220b), and accommodated in the housing; and
a battery (250) disposed on the first surface (220a) of the support member, and including a battery cell (251) and a tape (300) surrounding at least a portion of the battery cell (251),
wherein in a state in which the battery (250) is disposed on the first surface (220a) of the support member, at least a portion of the tape (300) surrounds the support member (220) and is disposed on a fourth surface (220d) stepped by a predetermined height from the first surface of the support member (200).

2. The electronic device of claim 1, wherein the tape (300) includes:
a double-sided tape (310); and
a wing-shaped tape (320) passing through a hole formed on the third surface of the support member to surround at least a portion of the support member 220 and disposed on the fourth surface parallel to the first surface of the support member.

3. The electronic device of claim 2, wherein the double-sided tape (310) and the wing-shaped tape (320) are disposed to at least partially overlap each other.

4. The electronic device of any one of claims 1 to 3, wherein the tape (300) is formed to surround the battery cell (251) in at least three different directions.

5. The electronic device of any one of claims 1 to 4, wherein the tape (300) includes:
a base portion corresponding to a first surface (251a) of the battery cell (251);
a first extension portion (322) extending from the base portion and configured to face a second surface (251b) of the battery cell (251); and
a second extension portion (324) extending from the base portion and configured to face a third surface (251c) of the battery cell 251.

6. The electronic device of claim 5, wherein the tape (300) includes:
a first adhesive portion (323) extending from the first extension portion; and
a second adhesive portion (325) extending from the second extension portion.

7. The electronic device of claim 5, wherein the first extension portion and the second extension portion of the tape (300) are extended from one end of the base portion.

8. The electronic device of claim 5, wherein the first extension portion and the second extension portion of the tape (300) are disposed at a position eccentric to one side with respect to a virtual line passing through a center of the electronic device and parallel to a width direction of the electronic device.

9. The electronic device of any one of claims 1 to 8, wherein the tape (300) includes:
a third extension portion (326) extending from the base portion and facing the second surface (251b) of the battery cell (251); and
a fourth extension portion (327) extending from the base portion and facing the third surface (251c) of the battery cell (251).

10. The electronic device of claim 9, wherein the tape (300) includes a handle portion (328) extending from the third extension portion or the fourth extension portion.

11. The electronic device of any one of claims 1 to 10, comprising a fixing member configured to fix the tape to the support member.

12. The electronic device of any one of claims 1 to 11, comprising a cover configured to fix the tape to the support member.

13. The electronic device of any one of claims 1 to 12, wherein the support member (220) includes a first portion including a first material and a second portion including a second material different from the first material, and
wherein the battery is disposed on the second portion of the support member

14. The electronic device of claim 13, wherein the first portion includes a non-metallic material, and the second portion includes a metallic material.

15. The electronic device of claim 1, wherein the tape (300) includes:
a fixing portion; and
a wing portion, wherein at least a portion of the wing portion passes through the hole formed on the third surface of the support member to surround at least a portion of the support member (220), and at least a portion of the wing portion is disposed on the fourth surface stepped by the predetermined height from the first surface of the support member.
